# EUROPEAN PATENT APPLICATION

(11) **EP 4 815 690 A1**
(43) Date of publication of application: **30.09.2026**
(21) Application number: 24894201.3
(22) Date of filing: 21.11.2024
(51) Int. Cl.: H10K 30/50, H10K 30/40, H10K 30/86, H10K 85/50, H10K 85/60

(54) **PHOTOELECTRIC CONVERSION ELEMENT AND SOLAR CELL MODULE**

(30) Priority: 22.11.2023 JP 2023198632
(71) Applicant: Enecoat Technologies Co., Ltd., Kyoto 613-0031 (JP)
(72) Inventor: KANEKO Ryuji, Kuse-gun, Kyoto 613-0031 (JP); NISHITANI Junichi, Kuse-gun, Kyoto 613-0031 (JP)
(74) Representative: Becker, Eberhard
(86) International application number: PCT/JP2024/041285
(87) International publication number: WO 2025/110210

(57) **Abstract**

The purpose of the present invention is to provide a photoelectric conversion element that shows excellent photoelectric conversion characteristics and has low variation. A photoelectric conversion element 10 according to one mode of the present invention has a structure in which a first electrode 12, a hole transport layer 13, a photoelectric conversion layer 14, an electron transport layer 15, and a second electrode 16 are layered in that order. The photoelectric conversion layer 14 includes a perovskite compound. The hole transport layer 13 includes an insulating compound and a monomolecular hole transport material. The hole transport material includes a compound represented by the chemical formula (I). (I): Ar¹-(L¹-X¹)n. In the chemical formula (I), Ar ¹ is a structure that includes an aromatic ring, atoms that constitute the aromatic ring may include heteroatoms, and Ar¹ may have a substituent other than -L¹-X¹. n is an integer 1 or greater, and if n is 2 or greater, the structures represented by -L¹-X¹ may be mutually identical or different. L¹ is a divalent linking group linking Ar¹ and X¹ or is a single bond. X¹ is a group capable of chemical bonding or hydrogen bonding with a p-type metallic oxide semiconductor.

## Description

### Technical Field

The present invention relates to a photoelectric conversion element and a solar cell module.

### Related Art

In recent years, solar power generation as a clean energy source has been attracting attention, and development of solar cells has been progressing. As one example, solar cells using a perovskite material in a light absorption layer have been rapidly attracting attention as a next-generation solar cell that can be manufactured at low cost. For example, Non-Patent Document 1 reports a solution-type solar cell using a perovskite material in a light absorption layer. Non-Patent Document 2 also reports that a solid-type perovskite solar cell exhibits high efficiency.

As basic structures of a perovskite solar cell, there are known a normal-type structure in which an electron transport layer, a light absorption layer (perovskite layer), a hole transport layer, and a back electrode are laminated in this order on an electrode, and an inverted-type structure in which a hole transport layer, a light absorption layer, an electron transport layer, and a back electrode are laminated in this order on an electrode. An electron transport layer having a porous shape may be provided between the electron transport layer and the perovskite layer. Among these, an organic semiconductor hole transport material is generally used in the hole transport layer (for example, Non-Patent Documents 3 to 10).

### Prior Art Documents

### Non-Patent Document

Non-Patent Document 1: Journal of the American Chemical Society, 2009, 131, 6050-6051.
Non-Patent Document 2: Science, 2012, 388, 643-647.
Non-Patent Document 3: ACS Appl. Mater. Interfaces, 2017, 9, 24778-24787.
Non-Patent Document 4: Energy Environ. Sci., 2014, 7, 1454-1460.
Non-Patent Document 5: J. Mater. Chem. A, 2014, 2, 6305-6309.
Non-Patent Document 6: J. Mater. Chem. A, 2015, 3, 12139-12144.
Non-Patent Document 7: J. Mater. Chem. A, 2018, 6, 7950-7958.
Non-Patent Document 8: ACS Appl. Mater. Interfaces, 2015, 7, 11107-11116.
Non-Patent Document 9: Energy & Environmental Science 2014, 7, 2963-2967.
Non-Patent Document 10: Adv. Energy Mater., 2018, 8, 1801892.

### SUMMARY OF INVENTION

### Technical Problem

However, conventional perovskite solar cells cannot be said to have sufficient photoelectric conversion efficiency. In order to improve the photoelectric conversion efficiency of solar cells, it is particularly important to improve characteristics of the hole transport layer. As a hole transport material for use in the hole transport layer, for example, a truxene compound (Non-Patent Document 3), a diketopyrrolopyrrole compound (Non-Patent Document 4), a thiophene compound (Non-Patent Documents 5 and 6), and dithienopyrrole (Non-Patent Document 7) have been reported. However, there are few reports of compounds capable of exhibiting photoelectric conversion efficiency sufficient to be considered useful as perovskite solar cells. Accordingly, Spiro-OMeTAD ([2,2',7,7'-tetrakis(N,N-di-p-methoxyphenylamino)-9,9'-spirobifluorene]), which was developed as a hole transport material for dye-sensitized solar cells, has been proposed; however, it is known to have low heat resistance (Non-Patent Document 8). A polymer material having a triphenylamine skeleton called PTAA (poly[bis(4-phenyl)(2,4,6-trimethylphenyl)amine]) is also known to have low light resistance. Furthermore, in the case of using these materials as a hole transport material for a p-buffer layer, it may be necessary to add a LiTFSI salt (lithium bis(trifluoromethanesulfonyl)imide) as an additive to improve conductivity, which is considered to be one of the causes of deterioration of an element (Non-Patent Document 9). In recent years, a carbazole-type hole transport material having a phosphonic acid has been reported (Non-Patent Document 10). This compound reacts with an indium tin compound (ITO) used as a transparent electrode and forms a monolayer on the transparent electrode. A hole transport compound forming the monolayer has been reported to have a photoelectric conversion efficiency exceeding 20% and is a highly excellent compound; however, in the case where the coverage of the hole transport layer with respect to the electrode is not sufficient, the electrode and the photoelectric conversion layer may come into contact with each other, resulting in a decrease in photoelectric conversion characteristics and insufficient durability.

Accordingly, the present invention aims to provide a photoelectric conversion element and a solar cell module that exhibit excellent photoelectric conversion characteristics and have small variation in characteristics.

### Solution to Problem

One aspect of the present invention is a photoelectric conversion element. In the photoelectric conversion element, a first electrode, a hole transport layer, a photoelectric conversion layer, an electron transport layer, and a second electrode are directly or indirectly laminated in this order. The photoelectric conversion layer includes a perovskite compound. The hole transport layer includes an insulating compound and a compound represented by the following chemical formula (I), the hole transport layer being in contact with a main surface of the first electrode on a side of the photoelectric conversion layer.

Ar¹-(L¹-X¹)n ... (I)

In chemical formula (I), Ar¹ is a structure including an aromatic ring, atoms that constitute the aromatic ring may include heteroatoms, and Ar¹ may have a substituent other than -L¹-X¹. n is an integer of 1 or greater, and in the case where n is 2 or greater, structures represented by -L¹-X¹ may be the same as or different from each other. L¹ is a divalent linking group that bonds Ar¹ and X¹, or is a single bond. X1 is a group capable of forming a chemical bond or hydrogen bond with the first electrode.

In the photoelectric conversion element of the above aspect, the hole transport layer may include a compound represented by the following chemical formula (II).

A¹-L²-X² ... (II)

A¹ is an atomic group including one or more substituents or structures selected from the group consisting of an alkoxy group, a hydroxy group, a carboxy group, a dihydroxyphosphoryl group, a dialkylphosphoryl group, a hydroxysulfonyl group, an amino group, a monoalkylamino group, a dialkylamino group, a monoarylamino group, a diarylamino group, a monoalkylaminocarbonyl group, a dialkylaminocarbonyl group, an alkylcarbonyloxy group, an alkoxycarbonyl group, an aminocarbonyl group, an aminocarbonylamino group, an alkylcarbonylamino group, an alkylsulfonylamino group, an aminosulfonyl group, and a nitrogen-containing heterocyclic group. L² is a divalent linking group that bonds A¹ and X², or is a single bond. X² is a group capable of forming a chemical bond or hydrogen bond with the first electrode.

The compound represented by chemical formula (I) may form a monolayer.

The insulating compound may be at least one selected from a metal oxide, a metal nitride, an insulating organic compound, and an organic-inorganic hybrid compound.

The insulating compound may have a particle shape. In this case, the insulating compound may have an average particle size ranging from 1 nm to 200 nm.

X¹ in chemical formula (I) may be selected from the group consisting of a dihydroxyphosphoryl group (-P=O(OH)₂), a carboxy group (-COOH), a sulfo group (-SO₃H), a boronic acid group (-B(OH)₂), a trihalogenated silyl group (-SiX₃, wherein X is a halo group), a trialkoxysilyl group (-Si(OR)₃, wherein R is an alkyl group), a trihydroxysilyl group, and a dialkylphosphoryl group. X² in chemical formula (II) may each independently be selected from the group consisting of a dihydroxyphosphoryl group (-P=O(OH)₂), a carboxy group (-COOH), a sulfo group (-SO₃H), a boronic acid group (-B(OH)₂), a trihalogenated silyl group (-SiX₃, wherein X is a halo group), a trialkoxysilyl group (-Si(OR)₃, wherein R is an alkyl group), a trihydroxysilyl group, and a dialkylphosphoryl group.

The perovskite compound may be an organic-inorganic perovskite compound.

A mass ratio of a mass (m1) of the compound represented by chemical formula (I) to a mass (m2) of the insulating compound may satisfy a relationhip of the following formula (A).$m 1 / m 2 = 1 / 10 to 1 / 20000$

An intermediate layer containing nickel oxide may be formed between the first electrode and the hole transport layer.

Another aspect of the present invention is a solar cell module. The solar cell module includes the photoelectric conversion element of any one of the aspects described above.

### Effects of Invention

According to the present invention, a photoelectric conversion element can be provided that exhibits excellent photoelectric conversion characteristics and has suppressed characteristic variation.

### BRIEF DESCRIPTION OF THE DRAWINGS

[FIG. 1] FIG. 1 is a cross-sectional view showing an example of a configuration of a photoelectric conversion element according to an embodiment.
[FIG. 2] FIG. 2 is a plan view showing a manufacturing process of a solar cell module according to an example.
[FIG. 3] FIG. 3 is a plan view showing a manufacturing process of a solar cell module according to an example.
[FIG. 4] FIG. 4 is a plan view showing a manufacturing process of a solar cell module according to an example.
[FIG. 5] FIG. 5 is a cross-sectional view taken along line A-A' of FIG. 4.

### DESCRIPTION OF THE EMBODIMENTS

The present invention will be described in further detail with examples. However, the present invention is not limited by the following description. In the following, a case will be described where a photoelectric conversion element according to an embodiment is a solar cell.

### [Photoelectric Conversion Element]

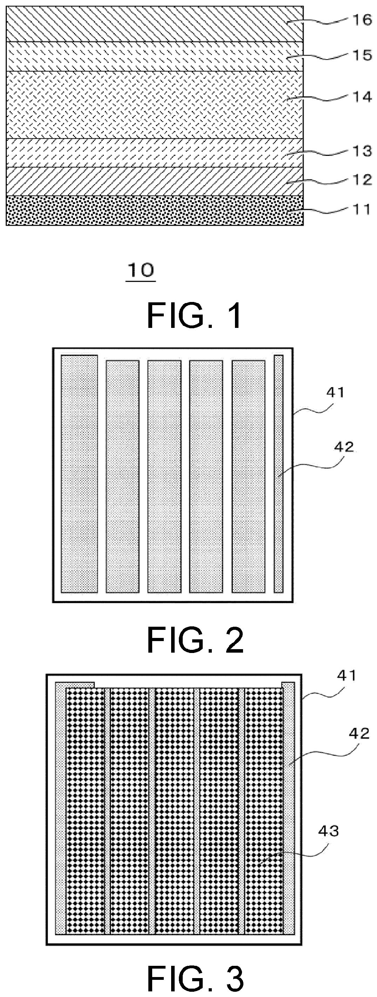

FIG. 1 is a cross-sectional view showing an example of a configuration of a photoelectric conversion element 10 according to an embodiment. FIG. 1 is schematically drawn with appropriate omissions, exaggerations, and the like for convenience of description. As shown in FIG. 1, the photoelectric conversion element 10 has a laminated structure in which a first electrode 12, a hole transport layer 13, a photoelectric conversion layer 14, an electron transport layer 15, and a second electrode 16 are laminated in this order on a support (also referred to as a substrate, a base material, or the like) 11. In the present embodiment, the electron transport layer 15 is present as shown in FIG. 1. However, the electron transport layer 15 is an optional layer, and the photoelectric conversion layer 14 and the second electrode 16 may be in contact with each other if desired photoelectric conversion characteristics can be obtained. In other words, it is sufficient if the first electrode 12, the hole transport layer 13, the photoelectric conversion layer 14, and the second electrode 16 are directly or indirectly laminated in this order. In addition to each layer shown in FIG. 1, for example, an interface layer may be provided between the photoelectric conversion layer 14 and the electron transport layer 15, or an electron injection layer may be provided between the electron transport layer 15 and the second electrode 16.

Hereinafter, each configuration of the photoelectric conversion element 10 will be described in detail.

### [Support]

The support 11 is not particularly limited. For example, a substrate that can be used in a photoelectric conversion element such as a general solar cell may be used as appropriate. Examples of the substrate include glass, a plastic plate, a plastic film, and an inorganic crystal. A substrate on which at least one of a metal film, a semiconductor film, a conductive film, and an insulating film is formed on a portion of or the entire surface of the substrate can also be suitably used as the support 11. The size, thickness, and the like of the support 11 are not particularly limited, and may be, for example, the same as or similar to those of a photoelectric conversion element such as a general solar cell.

### [First Electrode]

The first electrode 12 is, for example, a layer having a function of supporting the hole transport layer 13 and extracting holes from the photoelectric conversion layer 14. The first electrode 12 is, for example, a layer that functions as a cathode (positive electrode).

The first electrode 12 may be, for example, formed directly on the support 11. The first electrode 12 may be, for example, a transparent electrode formed from a conductor. The transparent electrode is not particularly limited, and examples thereof include a metal oxide, a nanowire of metal such as silver, a conductive polymer such as polyethylenedioxythiophene, and a carbon material such as carbon nanotubes or graphene. Preferred examples include a tin-doped indium oxide (ITO) film, an impurity-doped indium oxide (In₂O₃) film, an impurity-doped zinc oxide (ZnO) film, a fluorine-doped tin dioxide (FTO) film, a laminated film formed by laminating two or more of these, gold, silver, copper, aluminum, tungsten, titanium, chromium, nickel, and cobalt. These may be used alone or as a mixture of two or more, and may be a single layer or a laminate. These films may function as, for example, a diffusion barrier layer. The thickness of the first electrode 12 is not particularly limited, and is preferably adjusted so as to obtain a sheet resistance of, for example, 5 to 15 Ω/□ (per unit area). A method for forming the first electrode 12 is not particularly limited. The first electrode 12 can be obtained by a known film formation method depending on, for example, the material to be formed. The shape of the first electrode 12 is also not particularly limited, and may be, for example, a film shape or a lattice shape such as a mesh shape. A method for forming the first electrode 12 on the support 11 is not particularly limited, and may be, for example, a known method. For example, vacuum film formation such as vacuum deposition or sputtering is preferable. The first electrode 12 may also be patterned. A patterning method is not particularly limited, and examples thereof include a method for immersing in a laser or an etching solution and a method of patterning using a mask during vacuum film formation, and any of these methods may be used in the present embodiment. The first electrode 12 may be used in combination with metal wiring or the like for the purpose of reducing an electrical resistance value. A material of the metal wiring (metal lead wire) is not particularly limited, and examples thereof include aluminum, copper, silver, gold, platinum, and nickel. The metal lead wire may be formed on a first substrate by, for example, vapor deposition, sputtering, or pressure bonding, and the combined use may be achieved by providing an ITO or FTO layer on the metal lead wire, or by providing the metal lead wire on ITO or FTO.

### [Hole Transport Layer]

As shown in FIG. 1, the hole transport layer 13 contains an insulating compound and a hole transport material. At least a portion of the insulating compound and at least a portion of the hole transport material are in contact with a main surface of the first electrode 12 on the side of the photoelectric conversion layer 14. In the hole transport layer 13, the hole transport material functions as a hole transporter. By including an insulating compound in addition to the hole transport material as a material of the hole transport layer 13, the degree of scattering of light incident on the hole transport layer 13 increases. As a result, it is inferred that the amount of light captured in the photoelectric conversion layer 14 increases, and consequently the photoelectric conversion efficiency increases.

The insulating compound is a compound that does not readily conduct electricity, and generally exhibits a resistivity of 10⁸ to 10¹⁸ Ω·cm.

Examples of the insulating compound include at least one selected from a metal oxide, a metal nitride, an insulating organic compound, and an organic-inorganic hybrid compound.

Examples of the metal oxide include silica (SiO₂, having a refractive index of 1.48 and a volume resistivity of 1×10¹⁶ Ω·cm), alumina (Al₂O₃, having a refractive index of 1.64 and a volume resistivity of 1×10¹⁴ Ω·cm), zirconia (ZrO₂), ceria (CeO₂, having a refractive index of 2.13 and a volume resistivity of 1×10¹⁰ Ω·cm), magnesia (MgO), yttria (Y₂O₃, having a refractive index of 1.18 and a volume resistivity of 1×10¹³ Ω·cm), tantalum pentoxide (Ta₂O₅), hafnia (HfO₂), strontium oxide, lanthanum oxide, barium titanate (BaTiO₃, having a refractive index of 2.43 to 2.49 and a volume resistivity of 1×10¹² Ω·cm), and strontium titanate (SrTiO₃).

Examples of the metal nitride include aluminum nitride (AlN), silicon nitride (SiN), aluminum gallium nitride (AlGaN), and boron nitride (BN).

Examples of the insulating organic compound include acrylic resin, epoxy resin, and polystyrene. The organic-inorganic hybrid compound is a compound having both carbon atoms and silicon atoms, is preferably a compound having both a siloxane bond and a partial structure (such as a hydrocarbon group) having carbon atoms, and specific examples thereof include silsesquioxane.

Among these, it is preferable to use a metal oxide as the insulating compound.

The volume resistivity of the insulating compound is preferably 1×10⁸ Ω·cm or more, more preferably 1×10⁹ Ω·cm or more, and even more preferably 1×10¹⁰ Ω·cm or more. The volume resistivity of the insulating compound is preferably 1×10¹⁸ Ω·cm or less, more preferably 1×10¹⁷ Ω·cm or less, and even more preferably 1×10¹⁶ Ω·cm or less.

The refractive index of the insulating compound is preferably 1.20 or more, and more preferably 1.40 or more. The refractive index of the insulating compound is, for example, 2.50 or less. The refractive index of the insulating compound may be measured by a critical angle method.

A method for forming the hole transport layer 13 containing the insulating compound is not limited, and can be appropriately selected according to the purpose. A wet film formation method is preferable. As the wet film formation method, a method for preparing and coating a dispersion in which powder or sol of the insulating compound is dispersed is preferable.

The wet film formation method is not particularly limited, and can be appropriately selected according to the purpose. Examples thereof include a dip method, a spray method, a wire bar method, a spin coating method, a roller coating method, a blade coating method, and a gravure coating method.

As the wet printing method, various methods such as, for example, relief printing, offset printing, gravure printing, intaglio printing, rubber plate printing, and screen printing can be used.

A method for producing fine particles of the insulating compound is not particularly limited, and examples thereof include, in the case of a metal oxide, solid-phase reaction using known raw materials such as oxides and carbonates, coprecipitation, hydrothermal synthesis, and a sol-gel method. The shape of the fine particles is not particularly limited, and examples thereof include a spherical shape, an amorphous shape, and an anisotropic shape such as rod shape or plate shape. The insulating compound in the present embodiment preferably has a particle shape. In the case where the insulating compound has a particle shape, an average particle size of the particles is preferably 1 to 200 nm, more preferably 1 to 100 nm, and even more preferably 1.5 to 50 nm. The average particle size of the insulating compound is an average value calculated by measuring a diameter (or a major axis in the case of a non-circular shape) of 100 particles of the insulating compound by SEM. In a state where the hole transport layer 13 has been formed, the average particle size can be measured by photographing a cross-section of the hole transport layer 13 by SEM and measuring the diameter (or the major axis in the case of a non-circular shape) of 100 particles of the insulating compound. Before formation of the hole transport layer 13, the average particle size of the insulating compound of a particle shape used for forming the hole transport layer 13 may be measured in advance.

A method for preparing a dispersion of the insulating compound is not particularly limited, and can be appropriately selected according to the purpose. Examples thereof include a method of mechanically pulverizing using a known milling apparatus or the like. By this preparation method, a dispersion of the insulating compound can be prepared by dispersing the insulating compound in a particulate form alone, or a mixture of the insulating compound and a resin, in water or a solvent.

Examples of the resin used in the dispersion include a polymer or copolymer of a vinyl compound such as styrene, vinyl acetate, acrylic acid ester, and methacrylic acid ester, silicone resin, phenoxy resin, polysulfone resin, polyvinyl butyral resin, polyvinyl formal resin, polyester resin, cellulose ester resin, cellulose ether resin, urethane resin, phenol resin, epoxy resin, polycarbonate resin, polyarylate resin, polyamide resin, and polyimide resin. These may be used alone or in combination of two or more.

Examples of the solvent include water, an alcohol solvent, a ketone solvent, an ester solvent, an ether solvent, an amide solvent, a halogenated hydrocarbon solvent, and a hydrocarbon solvent. Examples of the alcohol solvent include methanol, ethanol, isopropyl alcohol, and α-terpineol. Examples of the ketone solvent include acetone, methyl ethyl ketone, and methyl isobutyl ketone. Examples of the ester solvent include ethyl formate, ethyl acetate, and n-butyl acetate. Examples of the ether solvent include diethyl ether, dimethoxyethane, tetrahydrofuran, dioxolane, and dioxane. Examples of the amide solvent include N,N-dimethylformamide, N,N-dimethylacetamide, and N-methyl-2-pyrrolidone. Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene. Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene. These may be used alone or in combination of two or more.

To a dispersion containing the insulating compound or a paste containing the insulating compound obtained by a sol-gel method or the like, an acid, a surfactant, a chelating agent, or the like may be added to prevent re-agglomeration of the particles. Examples of the acid include hydrochloric acid, nitric acid, and acetic acid. Examples of the surfactant include polyoxyethylene octylphenyl ether. Examples of the chelating agent include acetylacetone, 2-aminoethanol, and ethylenediamine. For the purpose of improving film formation properties, it is also an effective means to add a thickener. Examples of the thickener include polyethylene glycol, polyvinyl alcohol, and ethyl cellulose.

The hole transport layer 13 includes, in addition to the insulating compound described above, a compound represented by the following chemical formula (I).

Ar¹-(L¹-X¹)n ... (I)

In chemical formula (I), Ar¹ is a structure including an aromatic ring, atoms that constitute the aromatic ring may include heteroatoms, and Ar¹ may have a substituent other than -L¹-X¹. n is an integer of 1 or greater, and in the case where n is 2 or greater, structures represented by -L¹-X¹ may be the same as or different from each other. An upper limit of n is preferably 3 or 4. L¹ is a divalent linking group that bonds Ar¹ and X¹, or is a single bond. X1 is a group capable of forming a chemical bond or hydrogen bond with the first electrode 12.

### (Compound Represented by Chemical Formula (I))

In chemical formula (I), X¹ is each independently selected from the group consisting of a dihydroxyphosphoryl group (-P=O(OH)₂), a carboxy group (-COOH), a sulfo group (-SO₃H), a boronic acid group (-B(OH)₂), a trihalogenated silyl group (-SiX₃, wherein X is a halo group), a trialkoxysilyl group (-Si(OR)₃, wherein R is an alkyl group), a trihydroxysilyl group, and a dialkylphosphoryl group.

In chemical formula (I), Ar¹ is specifically, for example, preferably an aromatic ring group, a group formed by bonding a plurality of aromatic ring groups with a single bond, or a group formed by fusing one or more aromatic ring groups to a ring having no aromaticity.

The aromatic ring group may be monocyclic or polycyclic (for example, 2 to 14 rings), and may have one or more (for example, 1 to 10) heteroatoms (such as nitrogen atoms, sulfur atoms, and/or oxygen atoms). The number of ring member atoms of the aromatic ring group is preferably 5 to 40.

Examples of the aromatic ring group include a benzene ring group, a pyrrole ring group, a furan ring group, a thiophene ring group, and a group formed by fusing two or more (for example, 2 to 14) selected from these.

Examples of the aromatic ring group constituting the group formed by bonding a plurality of aromatic ring groups with a single bond include the aromatic ring groups described above. The number of aromatic ring groups bonded with a single bond is preferably, for example, 2 to 6.

Specific examples of the group formed by bonding a plurality of aromatic ring groups with a single bond include a biphenyl ring group and a bithiophene ring group.

Examples of the aromatic ring group constituting the group formed by fusing one or more aromatic ring groups to a ring having no aromaticity include the aromatic ring groups described above.

Among the groups formed by fusing one or more aromatic ring groups to a ring having no aromaticity, the number of aromatic ring groups fused to a ring having no aromaticity is preferably, for example, 2 to 6.

In the group formed by fusing one or more aromatic ring groups to a ring having no aromaticity, only one or a plurality of rings having no aromaticity may be present.

Among the groups formed by fusing one or more aromatic ring groups to a ring having no aromaticity, each ring having no aromaticity may independently be a monocyclic ring or a polycyclic ring (for example, 2 to 14 rings), and may have one or more (for example, 1 to 10) heteroatoms (such as nitrogen atoms, sulfur atoms, and/or oxygen atoms).

Specific examples of the group formed by fusing one or more aromatic ring groups to a ring having no aromaticity include a phenothiazine ring group and a 1,2:3,4:5,6:7,8-tetrakis[imino(1,2-phenylene)]cyclooctatetraene ring group.

In chemical formula (I), examples of L¹ being a divalent linking group include *1-alkylene group-*2 and *1-alkylene group-aromatic ring group-*2. Here, *1 represents a bonding position on the Ar¹ side, and *2 represents a bonding position on the X¹ side. The alkylene group may be linear or branched, and the number of carbon atoms is preferably 1 to 6. Examples of the aromatic ring group include the same aromatic ring groups as those described above as the aromatic ring group which can be Ar¹. The alkylene group and the aromatic ring group may further have a substituent.

Specific examples of the compound represented by chemical formula (I) include compounds (A-01) to (A-21) having the following structures.

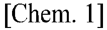

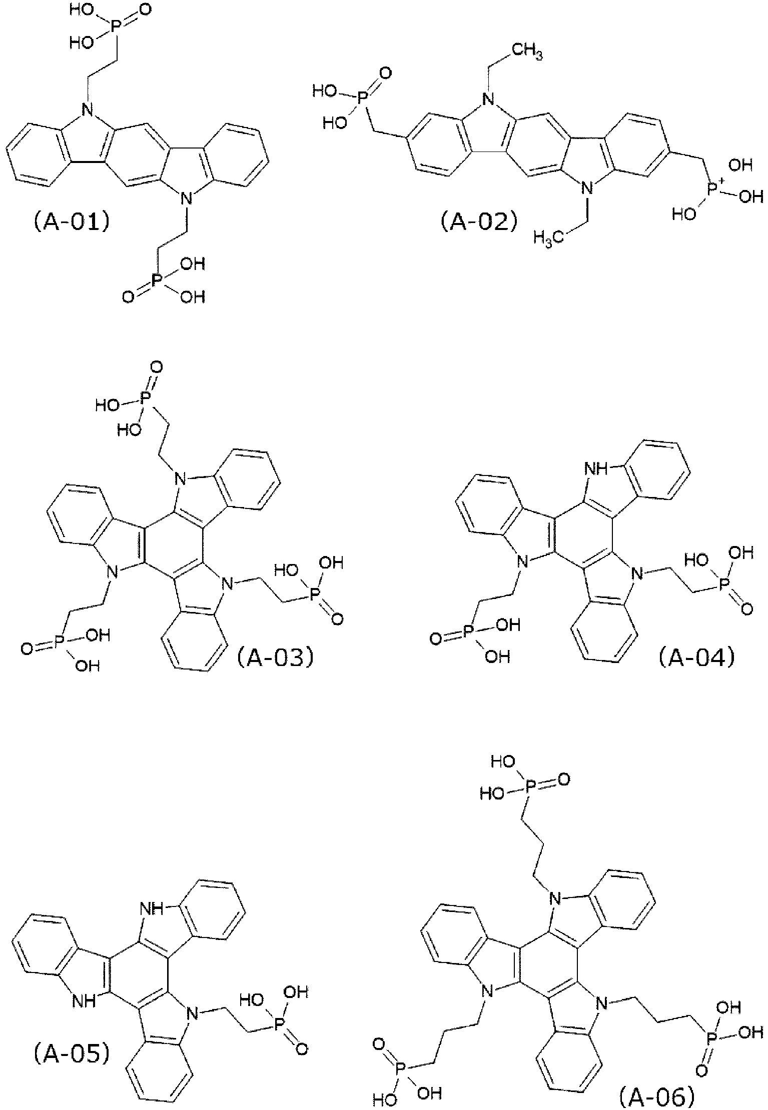

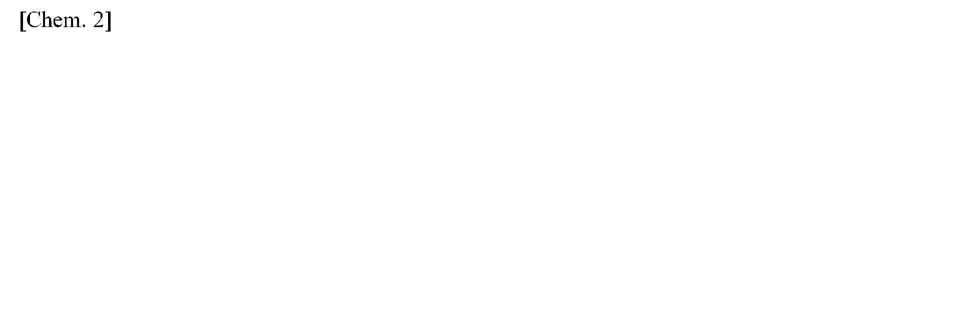

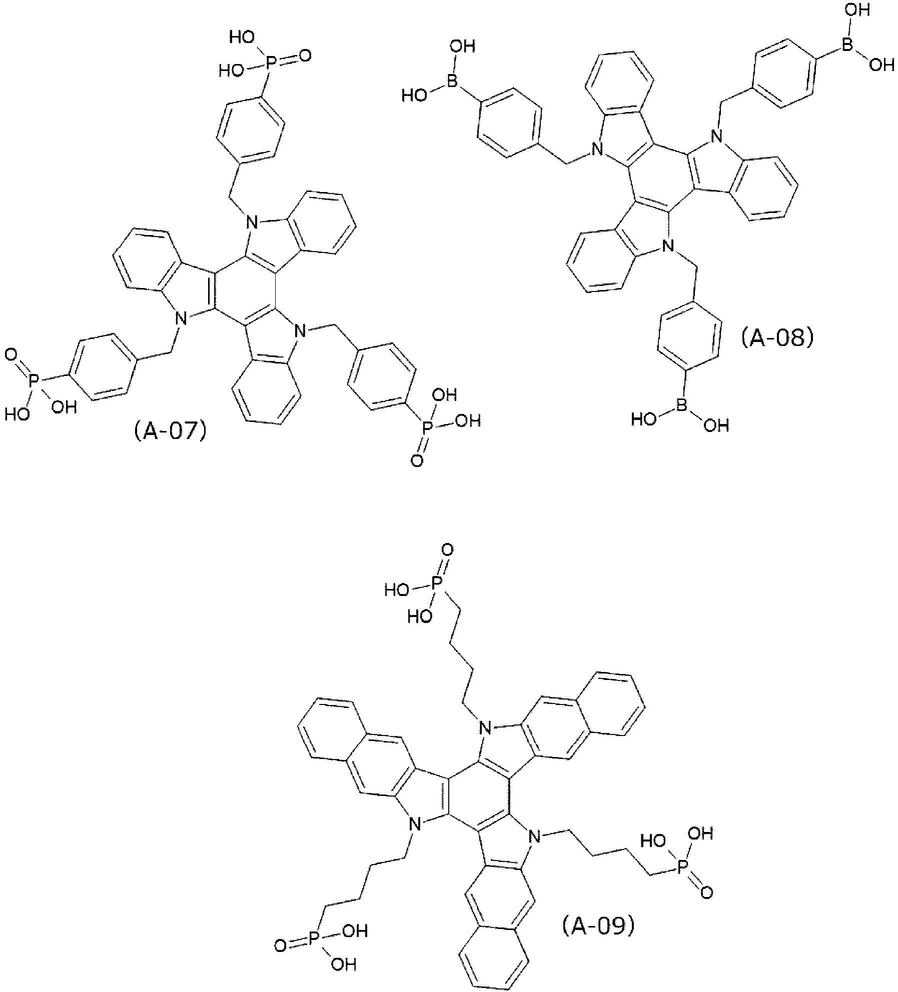

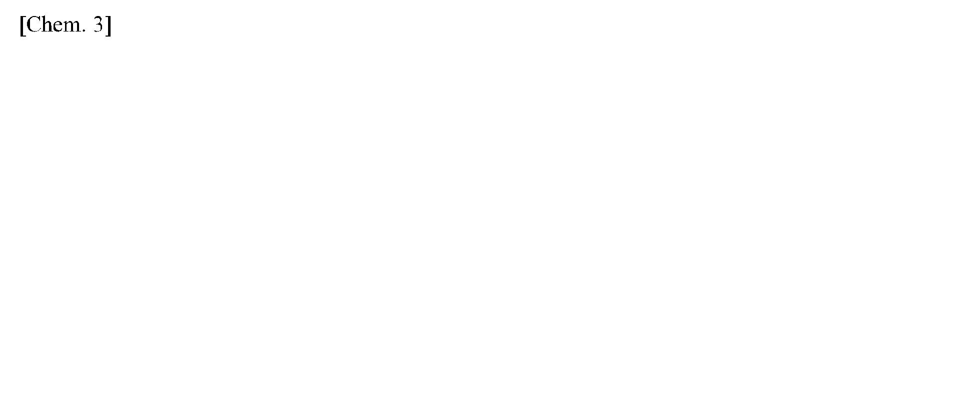

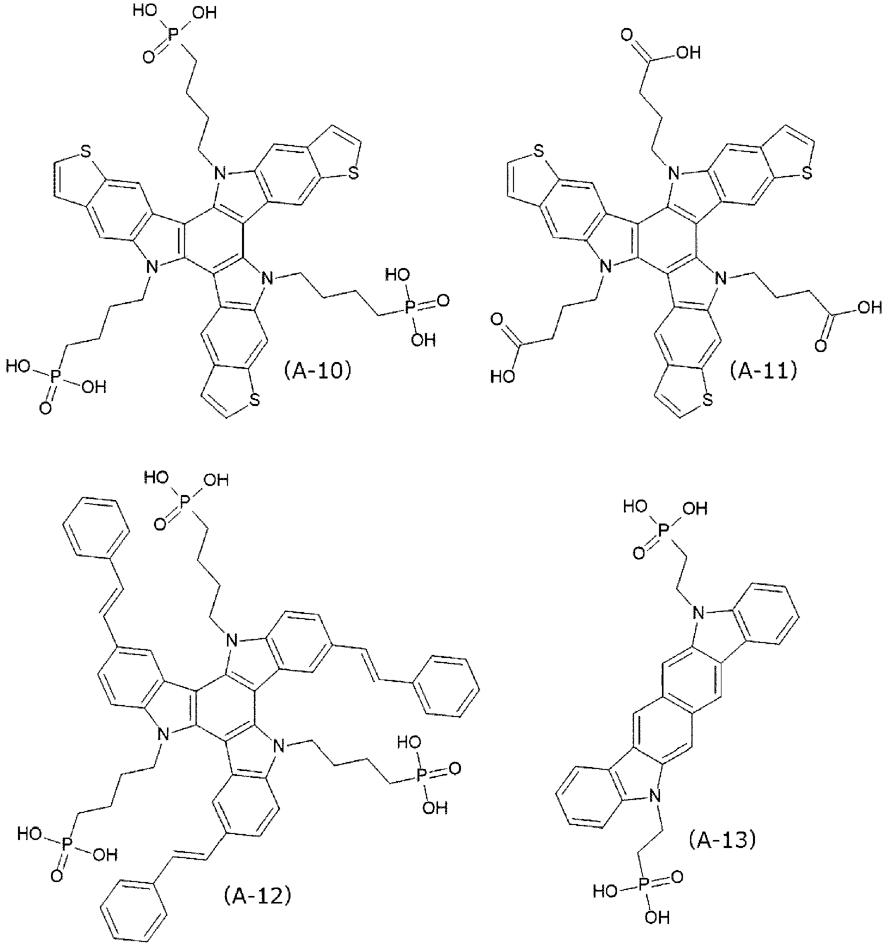

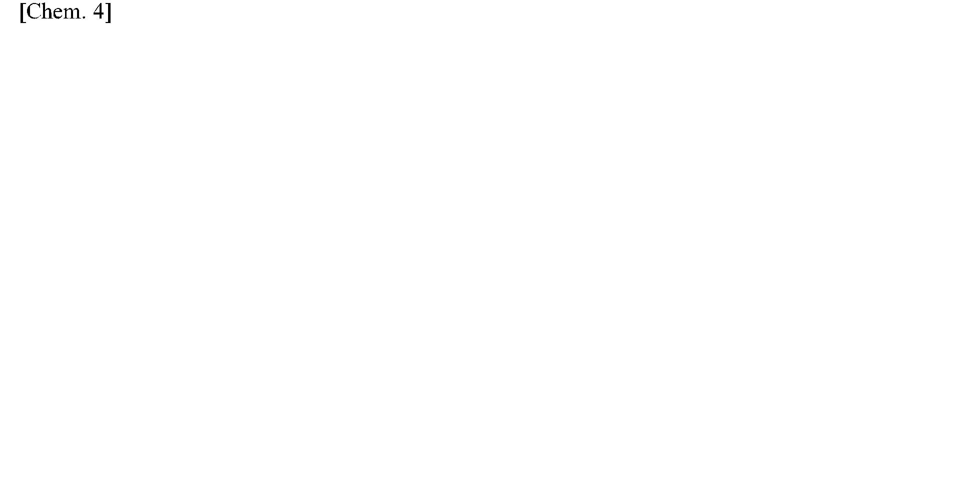

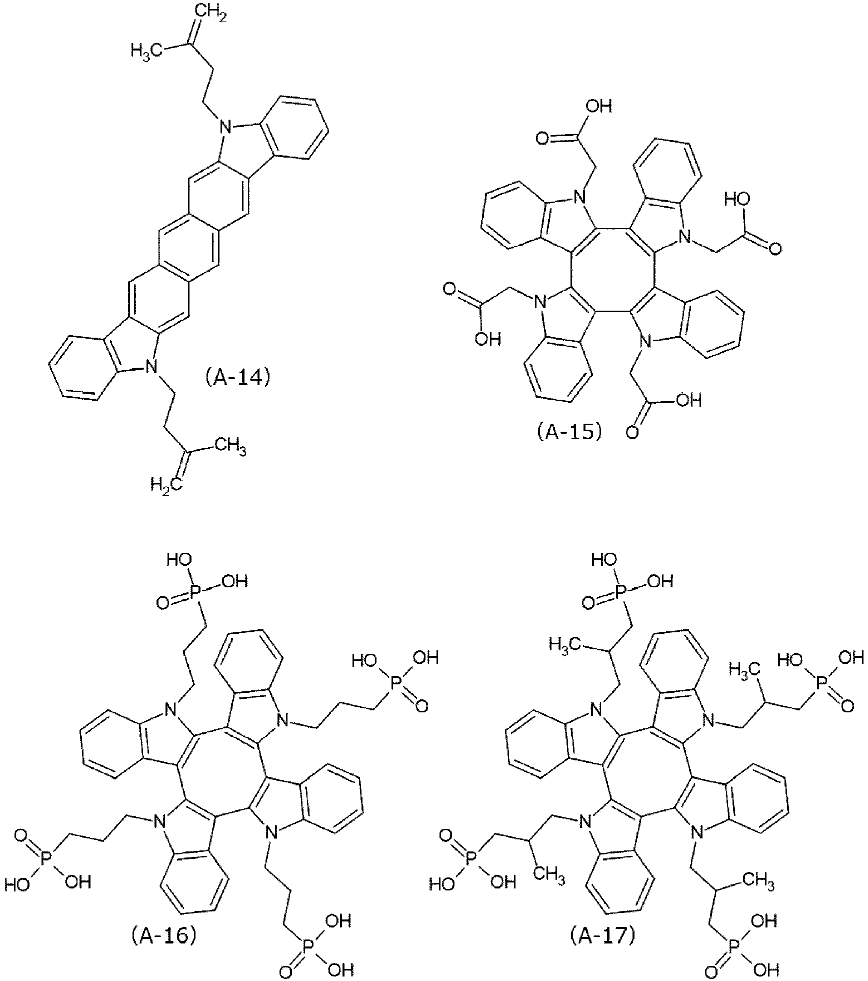

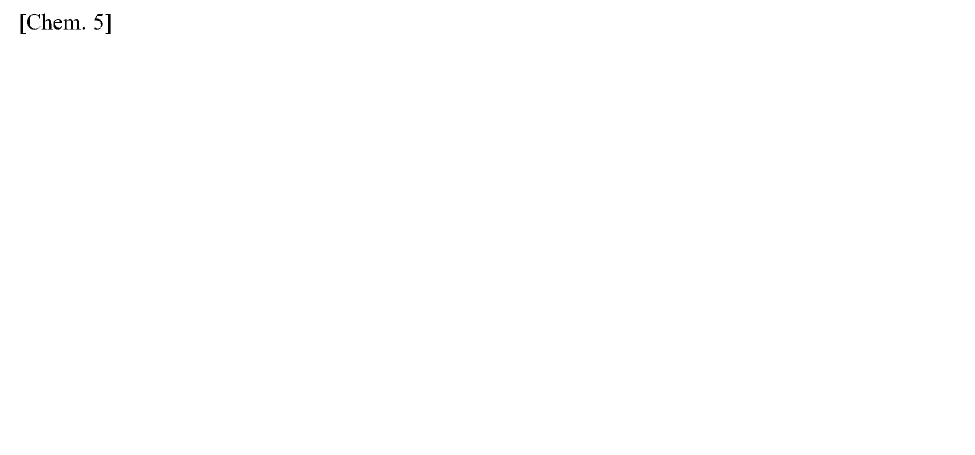

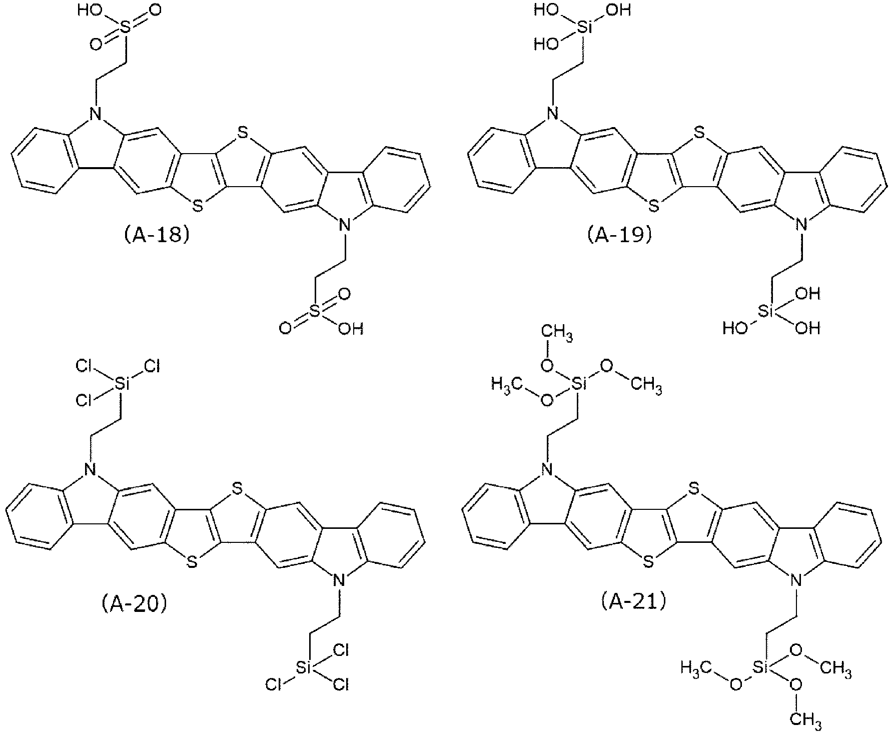

The compound represented by chemical formula (I) may, for example, be formed as a monolayer on the first electrode 12.

The compound represented by chemical formula (1) may be formed on a main surface of the first electrode 12 in a dispersed form, in other words, in a form in which gaps are present. The insulating compound described above may be formed in a form that fills the gaps.

### (Compound Represented by Chemical Formula (II))

The hole transport layer 13 may include, in addition to the insulating compound and the compound represented by chemical formula (I) described above, a compound represented by the following chemical formula (II). In other words, the compound represented by the following chemical formula (II) may be used in combination as a co-adsorbent. In a preferred aspect of the hole transport layer 13, the compound represented by chemical formula (II) forms a chemical bond or hydrogen bond with the first electrode 12.

A¹-L²-X² ... (II)

A¹ is an atomic group including one or more substituents or structures selected from the group consisting of: an organic amino group, such as a monoalkylamino group, a dialkylamino group, a monoarylamino group, a diarylamino group, an aminocarbonylamino group, an alkylcarbonylamino group, and an alkylsulfonylamino group; an alkoxy group; a hydroxy group; a carboxy group; a dihydroxyphosphoryl group; a dialkylphosphoryl group; a hydroxysulfonyl group; an amino group; a monoalkylaminocarbonyl group; a dialkylaminocarbonyl group; an alkylcarbonyloxy group; an alkoxycarbonyl group; an aminocarbonyl group; an aminosulfonyl group; and a nitrogen-containing heterocyclic group (which may or may not have aromaticity, may be monocyclic or polycyclic, in which the number of ring member atoms is preferably 5 to 15, the number of nitrogen atoms among the ring member atoms is preferably 1 to 5, and (preferably 1 to 3) heteroatoms other than nitrogen atoms may be included; examples include a pyridine ring group, a quinoline ring group, an aziridine ring group, an azetidine ring group, a pyrrolidine ring group, an imidazolidine ring group, an imidazolidin-2-one ring group, a 2,3-dihydro-1H-pyrrole ring group, a pyrrole ring group, a pyrazole ring group, an imidazole ring group, a 1H-1,2,3-triazole ring group, a 2H-1,2,3-triazole ring group, a thiazole ring group, a morpholine ring group, a piperidine ring group, a piperazine ring group, a pyrazine ring group, a hexamethyleneimine ring group, a 1H-azepine ring group, an indole ring group, a 2,3-trimethyleneindoline ring group, and a quinoxaline ring group). A¹ may be the substituent or structure listed above. In the case where the substituent or structure listed above has an alkyl group portion (including a portion that is an alkyl group in an alkoxy group), each alkyl group may independently be linear or branched, and the number of carbon atoms is preferably 1 to 8.

L² is a divalent linking group that bonds A¹ and X², or is a single bond. X² is a group capable of forming a chemical bond or hydrogen bond with the first electrode.

In the compound represented by chemical formula (II), A¹ has a hydrophilic function, whereby wettability with respect to a perovskite solution coated and formed on the hole transport layer 13 is improved. By improving the wettability with respect to the perovskite solution, coating can be performed to have a uniform thickness of a perovskite layer, and it is considered that an effect of reducing variation is achieved particularly in large-area coating.

In chemical formula (II), in the case where the atomic group represented by A¹ includes a monoarylamino group or a diarylamino group, examples of the aryl group portion in these groups include the same groups as those described above as the aromatic ring group which can be Ar¹. The atomic group represented by A¹ may be: an organic amino group, such as a monoalkylamino group, a dialkylamino group, a monoarylamino group, a diarylamino group, an aminocarbonylamino group, an alkylcarbonylamino group, or an alkylsulfonylamino group; an alkoxy group; a dialkylphosphoryl group; an amino group; a monoalkylaminocarbonyl group; a dialkylaminocarbonyl group; an alkylcarbonyloxy group; an alkoxycarbonyl group; an aminocarbonyl group; an aminosulfonyl group; or a nitrogen-containing heterocyclic group, and may further have one or more (preferably 1 to 6) substituents. The substituent that these groups may further have may be the same groups as those that X² or -L²-X² in chemical formula (II) may form. In the compound represented by chemical formula (II), it is also preferable that two or more (for example, 2 to 6) groups that -L²-X² in chemical formula (II) may form are present as a whole.

In chemical formula (II), X² is each independently selected from the group consisting of a dihydroxyphosphoryl group (-P=O(OH)₂), a carboxy group (-COOH), a sulfo group (-SO₃H), a boronic acid group (-B(OH)₂), a trihalogenated silyl group (-SiX₃, wherein X is a halo group), a trialkoxysilyl group (-Si(OR)₃, wherein R is an alkyl group), a trihydroxysilyl group, and a dialkylphosphoryl group.

In chemical formula (II), L² being a divalent linking group includes, for example, an alkylene group (which may be linear or branched, and the number of carbon atoms is preferably 1 to 8), a vinylene group, a vinylidene group, an acetylene group, an aromatic ring group (for example, an aromatic ring group described as the aromatic ring group which can be Ar¹ in chemical formula (I)), a non-aromatic ring group (which may be monocyclic or polycyclic and may have a heteroatom; examples include a piperazine ring group), -O-, -S-, -NR^{N}- (R^{N} is a hydrogen atom or an alkyl group; the alkyl group may be linear or branched, and the number of carbon atoms is preferably 1 to 8), and a divalent linking group consisting of a combination of two or more (for example, 2 to 6) of these. The divalent linking group consisting of a combination of two or more of the above may be a combination of the same type of groups (however, combinations in which alkylene groups are bonded consecutively are not included).

These divalent linking groups may further have one or more (for example, 1 to 6) substituents where possible, and may, for example, have the same groups as those described as one or more (for example, 1 to 6) A¹ or X² as substituents.

Specific examples of the compound represented by chemical formula (II) include 3-methoxypropionic acid, 3-hydroxypropionic acid, 2-hydroxypropionic acid, malonic acid, succinic acid, glutaric acid, adipic acid, sebacic acid, phthalic acid, terephthalic acid, maleic acid, fumaric acid, citraconic acid, mesaconic acid, methylenesuccinic acid, allylmalonic acid, isopropylidene succinic acid, acetylenedicarboxylic acid, dimethyl terephthalate, diethyl terephthalate, 4,4'-biphenyldicarboxylic acid, diethyl 4,4'-biphenyldicarboxylate, 4-methoxybenzoic acid, 3,4-dimethoxybenzoic acid, 4-(methylamino)benzoic acid, 4-(methylamino)benzenesulfonic acid, 4-(methylamino)butanoic acid, 3-(carboxymethylamino)propionic acid, 6-acetoxy-2-naphthoic acid, acetylsalicylic acid, 4-(methoxycarbonyl)cyclohexanecarboxylic acid, 4-(methoxycarbonyl)phenylboronic acid, 4-(N,N-diethylaminocarbonyl)phenylboronic acid, 3-(methylaminocarbonyl)acrylic acid, N-(aminocarbonyl)aspartic acid, 4-acetylaminobenzoic acid, 2-(acetylamino)acrylic acid, gallic acid, 4-pyridinecarboxylic acid, 6-quinolinecarboxylic acid, aspartic acid, 2,2-diethoxyethylphosphonic acid, methylenediphosphonic acid, 1,2-ethylenediphosphonic acid, tetraethyl 1,2-ethylenediphosphonate, 1,3-propylenediphosphonic acid, 3,4-dimethoxyphenylphosphonic acid, (4-hydroxybenzyl)phosphonic acid, 4-hydroxyphenylphosphonic acid, [3-(3-carboxypiperazin-1-yl)propyl]phosphonic acid, (pyridin-4-ylmethyl)phosphonic acid, (pyridin-3-ylmethyl)phosphonic acid, 4-phosphonobenzoic acid, 3-phosphonopropionic acid, 4-phosphonobutyric acid, diethyl (4-methoxybenzyl)phosphonate, p-carboxybenzenesulfonylamide, 2-(dimethylamino)ethanesulfonic acid, and 1,2-ethanesulfonic acid.

Specific examples of L² include alkylene such as 1,1-ethylene, 1,2-ethylene, 1,3-propylene, and 2-ethyl-1,6-hexylene, in which a portion of the alkylene may be alkenylene having a carbon-carbon double bond or alkynylene having a triple bond. Further examples include: arylene, such as 1,2-phenylene, 1,4-phenylene, 1,5-naphthylene, and 4,4'-biphenylene; and divalent heterocycle, such as 2,5-thienylene, 5,5'-bithienylene, 2,5-thieno[3,2-b]thienylene, and 2,6-pyridylene.

In the compound represented by chemical formula (II) above, examples of a case where a salt is formed from a nitrogen atom and an anion include ammonium salt, aziridinium salt, azirinium salt, azetidinium salt, pyrrolidinium salt, pyrrolinium salt, pyrazolinium salt, pyrrolinium salt, pyrazolinium salt, imidazolinium salt, triazolinium salt, tetrazolinium salt, piperidinium salt, piperazinium salt, pyridinium salt, pyrazinium salt, morpholinium salt, thiazolinium salt, azepanium salt, azepinium salt, indolinium salt, indolinium salt, quinolinium salt, isoquinolinium salt, quinoxalinium salt, phenanthrolinium salt, and phenazinium salt. An acid that reacts with the compound represented by chemical formula (II) above to form a salt may be any or a mixture of organic acids and inorganic acids described later as an acid that forms an acid addition salt.

Specific examples of the compound represented by chemical formula (II) include compounds (B-01) to (B-52) having the following structures.

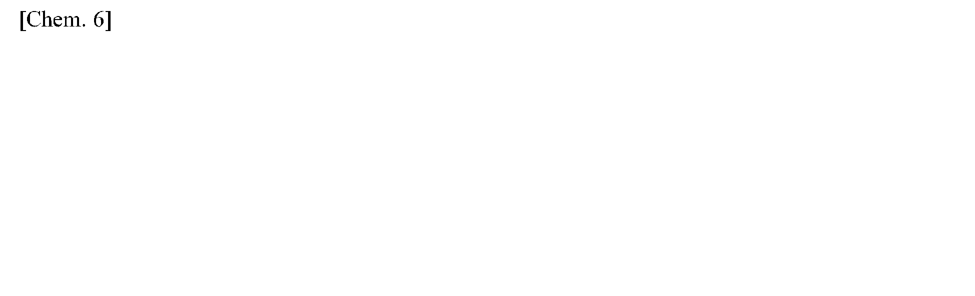

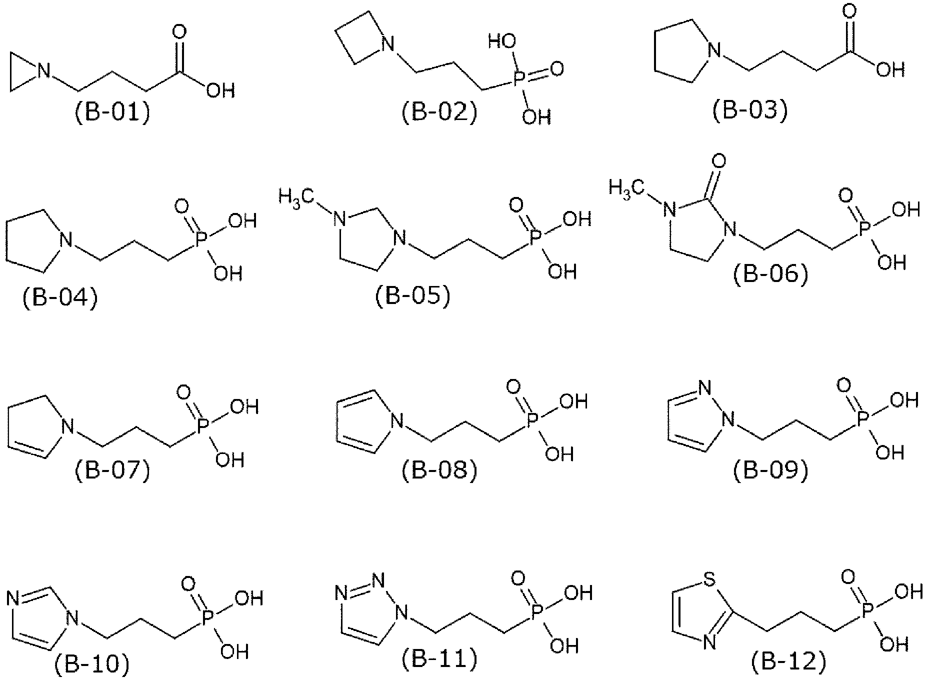

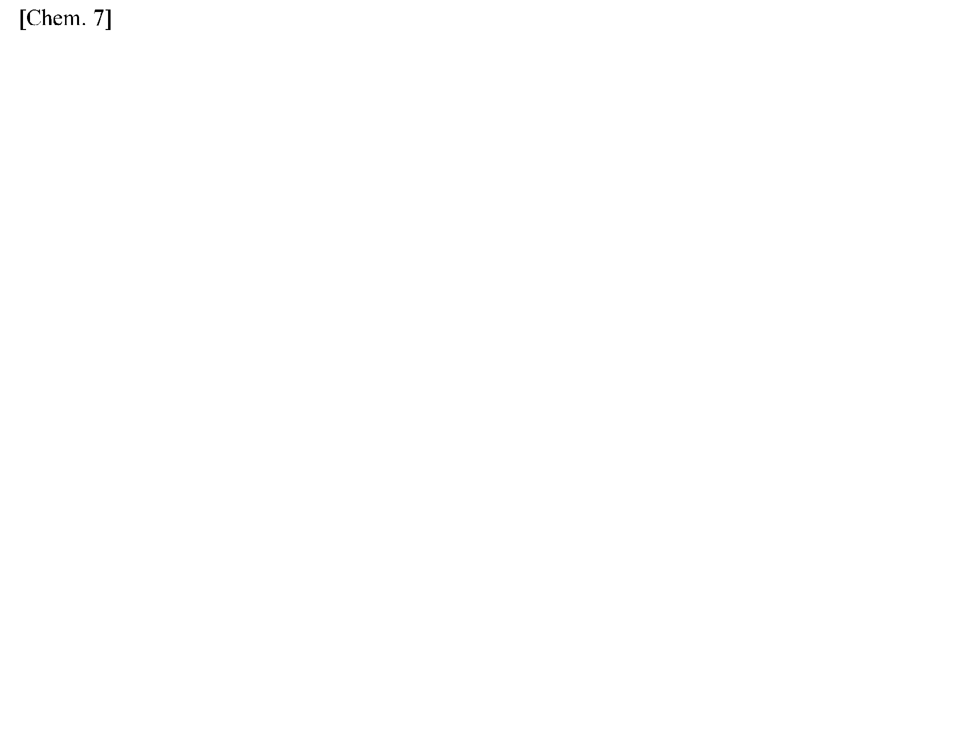

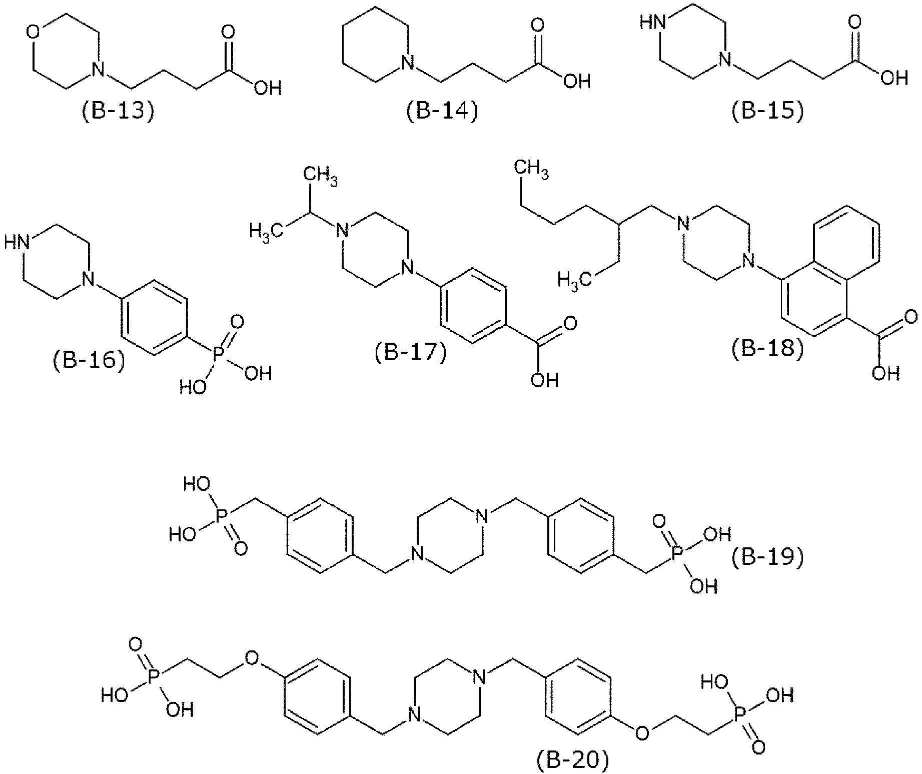

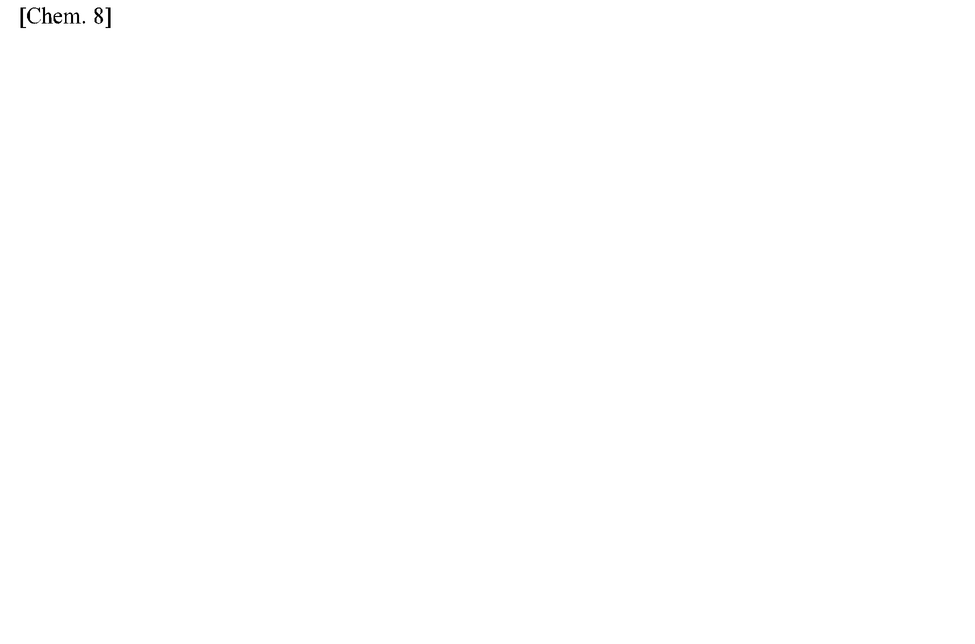

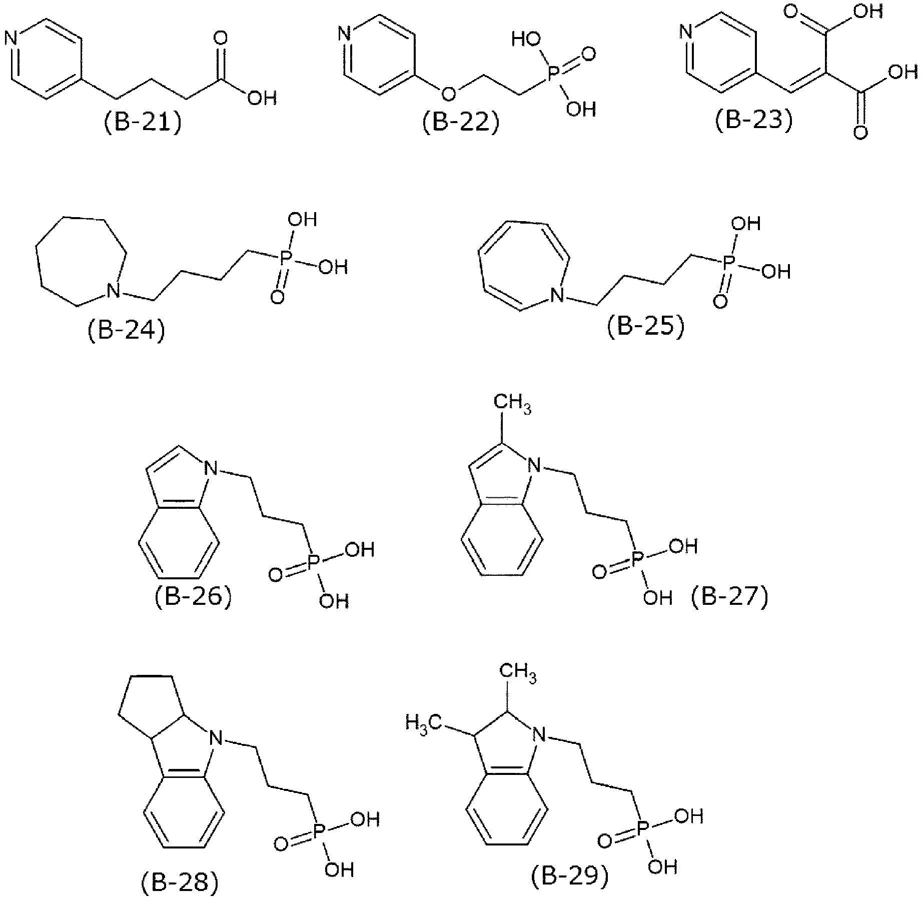

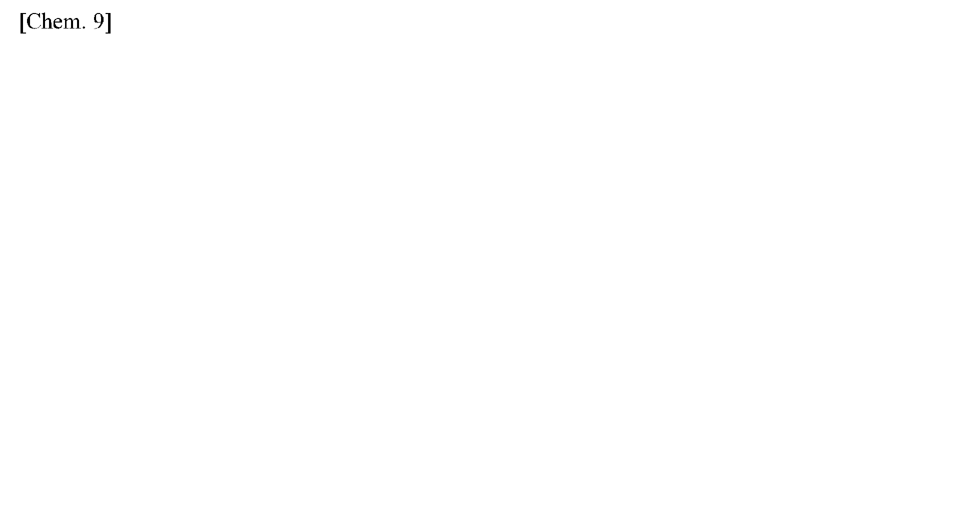

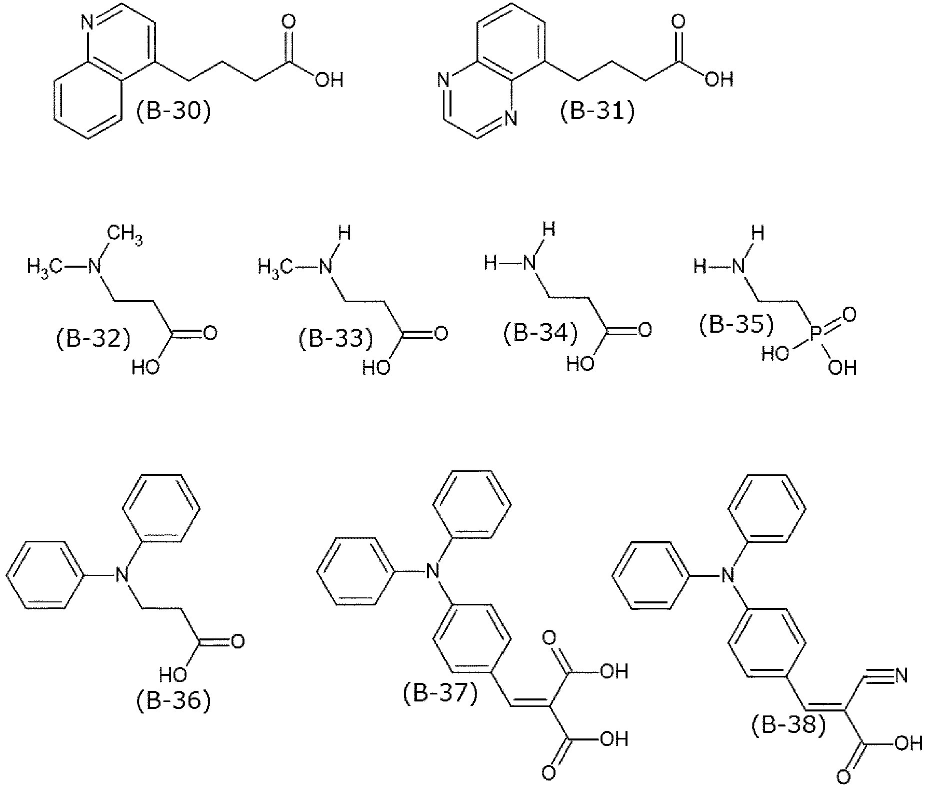

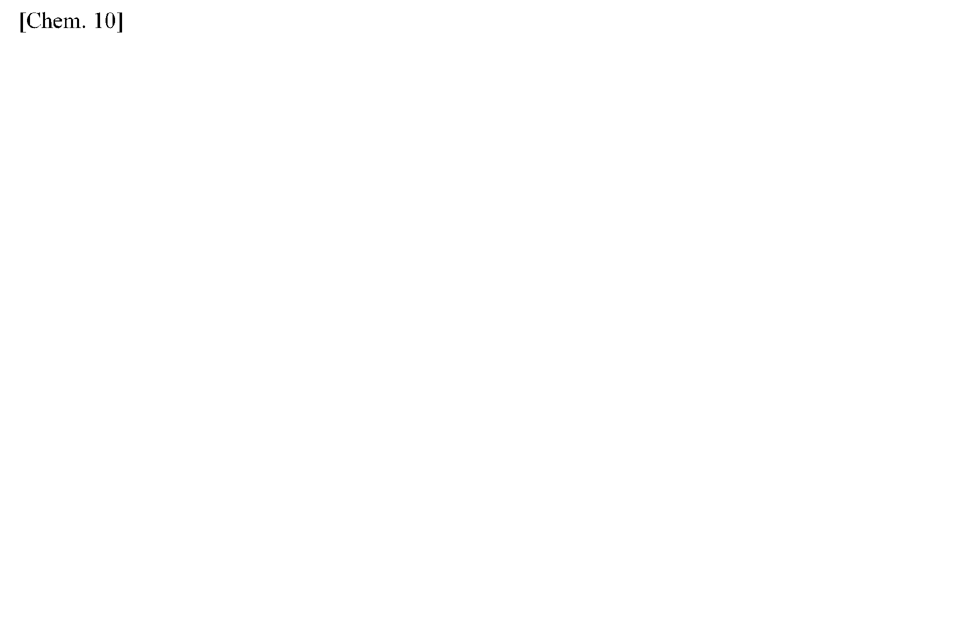

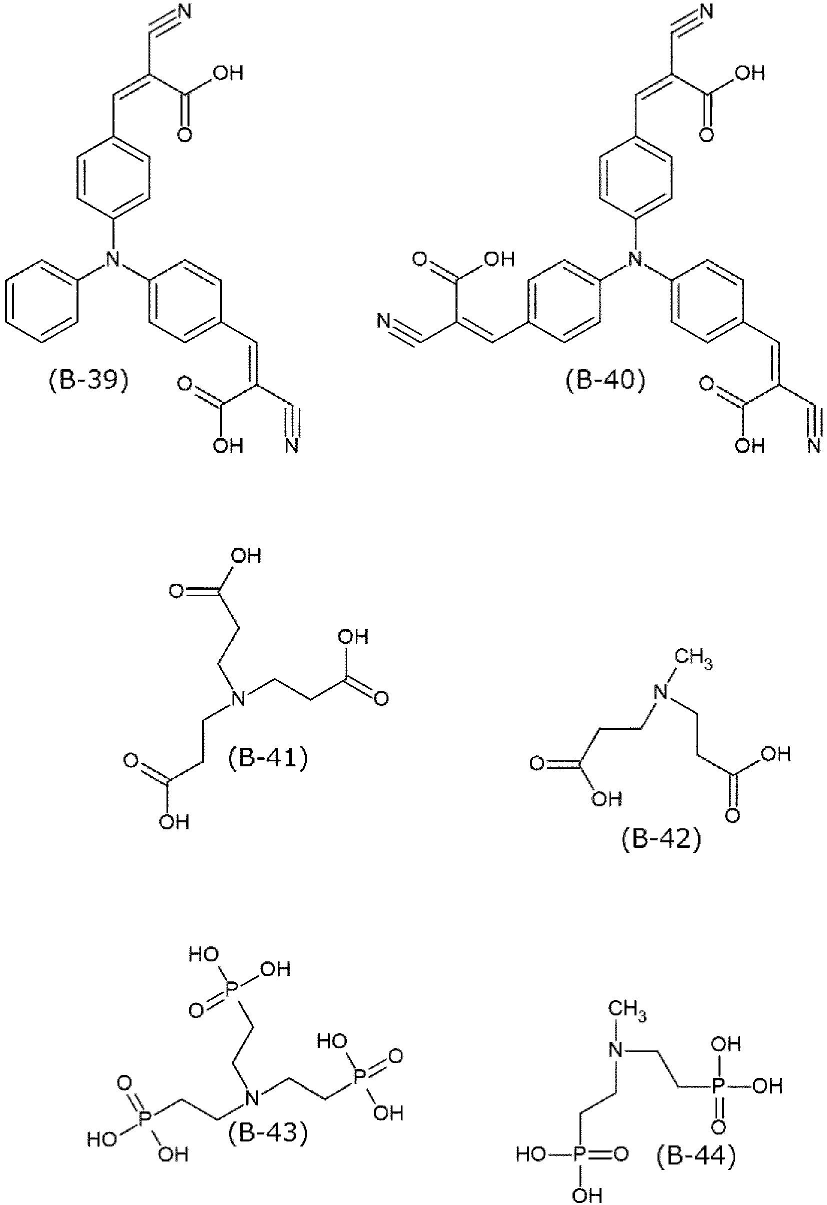

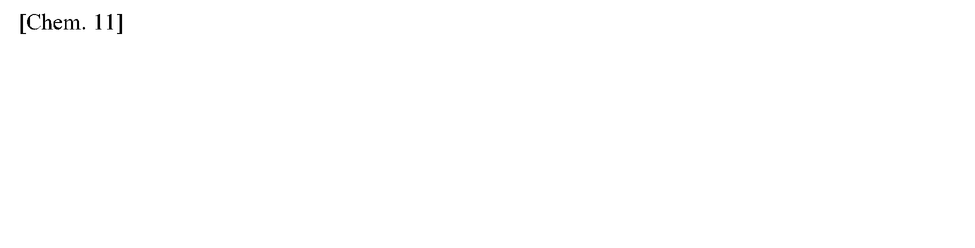

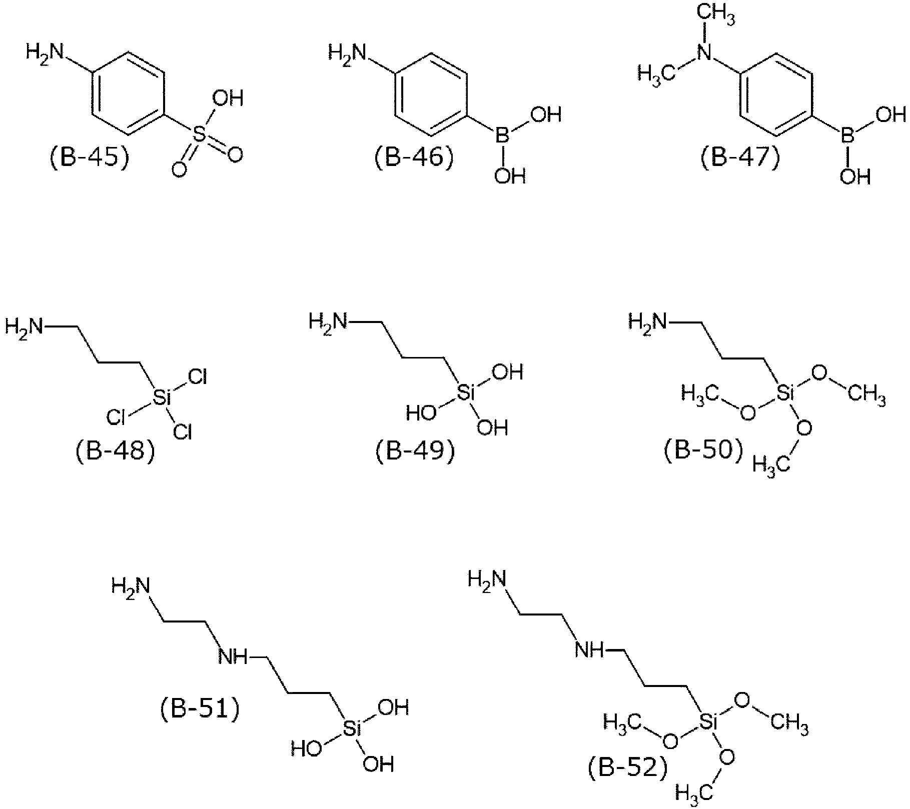

The compound represented by chemical formula (II) may, for example, be formed as a monolayer on the first electrode 12.

In the hole transport layer 13, a total content of the compound represented by chemical formula (I) (including the salt form described above) and the compound represented by chemical formula (II) (including the salt form described above) is preferably 70 to 100% by mass, more preferably 90 to 100% by mass, and even more preferably 99 to 100% by mass, relative to the mass of the hole transport layer 13.

A molar ratio of the compound represented by chemical formula (II) (including the salt form described above) to the compound represented by chemical formula (I) (including the salt form described above) is preferably 1:100 to 1:1, more preferably 1:80 to 1:2, and even more preferably 1:50 to 1:5.

In the hole transport layer 13, a ratio expressed by [mass of compound represented by chemical formula (I)]/[mass of insulating compound] is preferably 1/10 to 1/20000, and more preferably 1/50 to 1/10000.

The mass of the compound represented by chemical formula (I) can be calculated, for example, from the amount of adsorption measured by cyclic voltammetry. The mass of the insulating compound is obtained by making a film by spin coating from a solution in which the insulating compound is dispersed onto a surface such as glass, and observing a cross-section of the obtained film with an electron microscope. A measured film thickness is multiplied by 0.74 to obtain a numerical value from which a weight is calculated, assuming that nanoparticles are closely packed.

The film thickness of the hole transport layer 13 is preferably 10 to 300 nm, more preferably 20 to 150 nm, and even more preferably 30 to 100 nm.

### (Method for Forming Hole Transport Layer)

A method for forming the hole transport layer 13 is not particularly limited, and examples thereof include: a method in which the compound represented by chemical formula (I), or the compounds represented by chemical formula (I) and chemical formula (II) are adsorbed onto the first electrode 12, and then a dispersion of the insulating compound is coated; a method in which a dispersion of the insulating compound is coated onto the first electrode 12, and then the compound represented by chemical formula (I), or the compounds represented by chemical formula (I) and chemical formula (II) are adsorbed; and a method in which the compound represented by chemical formula (I), or the compounds represented by chemical formula (I) and chemical formula (II) are contained in a dispersion of the insulating compound, and the solution is coated onto the first electrode 12. Particularly, among these, most preferable is the method in which the compound represented by chemical formula (I), or the compounds represented by chemical formula (I) and chemical formula (II) are adsorbed onto the first electrode 12, and then a dispersion of the insulating compound is coated.

The method for adsorbing the compound represented by chemical formula (I), or the compounds represented by chemical formula (I) and chemical formula (II) onto the first electrode 12 is not particularly limited. For example, the compound represented by chemical formula (I), or the compounds represented by chemical formula (I) and chemical formula (II) may be dissolved in a solvent and brought into contact with the first electrode 12 to form a bond. The bonding between the compound represented by chemical formula (I) and the first electrode 12 as well as the bonding between the compound represented by chemical formula (II) and the first electrode 12 are not particularly limited, and may be either physical bonding or chemical bonding. The type of the bond is also not particularly limited, and may be, for example, any of a hydrogen bond, an ester bond, and a chelate bond. A solvent for dissolving the compound represented by chemical formula (I) and the compound represented by chemical formula (II) is also not particularly limited, and may be, for example, one or both of water and an organic solvent. More specific examples of the solvent include: water; alcohols, such as methanol, ethanol, and 2-propanol; ethers, such as diethyl ether and diisopropyl ether; ketones, such as acetone and methyl isobutyl ketone; esters, such as ethyl acetate, isobutyl acetate, and γ-butyrolactone; heterocycles, such as tetrahydrofuran and thiophene; amides, such as N,N-dimethylformamide, N,N-dimethylacetamide, and N-methylpyrrolidone; sulfoxides, such as dimethyl sulfoxide; sulfones, such as diethyl sulfone and sulfolane; nitriles, such as acetonitrile and 3-methoxypropionitrile; aromatic compounds, such as benzene, toluene, and chlorobenzene; a halogenated solvent, such as dichloromethane and chloroform; and a fluorinated solvent, such as chlorofluorocarbon, hydrochlorofluorocarbon, and hydrofluorocarbon. These may be used alone or as a mixture of two or more types.

A specific method for adsorbing the compound represented by chemical formula (I) or the compounds represented by chemical formula (I) and chemical formula (II) onto the first electrode 12 to form a monolayer is not particularly limited, and examples thereof include a known method such as a dipping method, a spray method, a spin coating method, and a bar coating method. A temperature during adsorption is not particularly limited, and is preferably -20 °C to 100 °C, and more preferably 0 °C to 50 °C. The adsorption time is also not particularly limited, and is preferably, for example, 1 second to 48 hours, and more preferably 10 seconds to 1 hour.

After the adsorption treatment, for example, washing may or may not be performed. The washing method is also not particularly limited. For example, a known method may be used as appropriate.

After the adsorption treatment or after the washing, a heat treatment may or may not be performed. A temperature of the heat treatment is preferably 50 °C to 150 °C, and more preferably 70 °C to 120 °C. The heat treatment time is preferably 1 second to 48 hours, and more preferably 10 seconds to 1 hour. The heat treatment may be performed, for example, in the atmosphere or in a vacuum.

In the present embodiment, the "substituent" is not particularly limited, and examples thereof include an alkyl group, an alkenyl group, an alkynyl group, an unsaturated aliphatic hydrocarbon group, an alkoxy group, an aralkyl group, an aryl group, an arylalkenyl group, a heteroaryl group, a halogen atom (such as a fluorine atom, a chlorine atom, and/or a bromine atom), a hydroxy group (-OH), a mercapto group (-SH), an alkylthio group (-SR, wherein R is an alkyl group), an amino group, a sulfo group, a nitro group, a diazo group, a cyano group, a nitrile group, and a trifluoromethyl group.

In the present embodiment, in the case where an isomer such as a tautomer or stereoisomer (for example, geometric isomer, conformational isomer, and optical isomer) is present in a compound, any of the isomers can be used in the present embodiment unless otherwise specified. In the present embodiment, in the case where the compound represented by chemical formula (I) or chemical formula (II) is capable of forming a salt, the salt can also be used in the present embodiment unless otherwise specified. The salt may be an acid addition salt or a base addition salt. Further, an acid forming the acid addition salt may be an inorganic acid or an organic acid, and a base forming the base addition salt may be an inorganic base or an organic base. The inorganic acid is not particularly limited, and examples thereof include sulfuric acid, phosphoric acid, hydrofluoric acid, hydrochloric acid, hydrobromic acid, hydroiodic acid, hypofluorous acid, hypochlorous acid, hypobromous acid, hypoiodous acid, fluorous acid, chlorous acid, bromous acid, iodous acid, fluoric acid, chloric acid, bromic acid, iodic acid, perfluoric acid, perchloric acid, perbromic acid, and periodic acid. The organic acid is also not particularly limited, and examples thereof include p-toluenesulfonic acid, methanesulfonic acid, oxalic acid, p-bromobenzenesulfonic acid, carbonic acid, succinic acid, citric acid, benzoic acid, and acetic acid. The inorganic base is not particularly limited, examples thereof include ammonium hydroxide, alkali metal hydroxide, alkaline earth metal hydroxide, carbonate, and bicarbonate, and more specific examples thereof include sodium hydroxide, potassium hydroxide, potassium carbonate, sodium carbonate, sodium bicarbonate, potassium bicarbonate, calcium hydroxide, and calcium carbonate. The organic base is also not particularly limited, and examples thereof include ethanolamine, triethylamine, and tris(hydroxymethyl)aminomethane. A method for producing these salts is also not particularly limited, and the salts can be produced, for example, by a method for appropriately adding an acid or a base as described above to the compound by a known method.

A mass ratio of a mass (m1) of the compound represented by chemical formula (I) to a mass (m2) of the insulating compound preferably satisfies a relationship of the following formula (A).$m 1 / m 2 = 1 / 10 to 1 / 20000$ (A)

### [Photoelectric Conversion Layer]

The photoelectric conversion layer 14 is not particularly limited, and may be, for example, the same as a photoelectric conversion layer used in a photoelectric conversion element such as a general solar cell. The photoelectric conversion layer 14 includes, for example, a perovskite compound. The perovskite compound may be, for example, an organic-inorganic perovskite compound represented by the following chemical formula (III).

X_{α}Y_{β}Z_{γ} ... (III)

In chemical formula (III), a ratio of α:β:γ is 3:1:1, and β and γ represent integers greater than 1. X represents a halogen ion, Y represents an organic compound having an amino group, and Z represents a metal ion. The photoelectric conversion layer 14 including a perovskite compound is preferably disposed adjacent to the electron transport layer 15 described later. The ratio of α:β:γ is not necessarily 3:1:1, and may be, for example, 3:1.05:0.95.

X in chemical formula (III) is not particularly limited and can be appropriately selected according to the purpose. Examples thereof include halogen ions such as chlorine, bromine, and iodine. These may be used alone or in combination of two or more.

Examples of Y in chemical formula (III) include alkylamino compound ions (organic compounds having an amino group) such as methylamine, ethylamine, n-butylamine, and formamidine, and, not limited to organic compounds, alkali metal ions such as cesium, potassium, and rubidium. The alkylamino compound ions and the alkali metal ions may each be used alone or in combination of two or more. An organic compound (alkylamino compound ion) and an inorganic compound (alkali metal ion) may also be used in combination. For example, cesium ions and formamidine may be used in combination.

Z in chemical formula (III) is not particularly limited and can be appropriately selected according to the purpose. Examples thereof include a metal such as lead, indium, antimony, tin, copper, and bismuth. These may be used alone or in combination of two or more. Among these, a combination of lead and tin is particularly preferable. The perovskite layer preferably exhibits a layered perovskite structure in which a layer composed of a halogenated metal and a layer in which organic cation molecules are arranged are alternately laminated. The perovskite layer may contain an alkali metal. The case where the perovskite layer contains at least an alkali metal is advantageous in that the output increases. Examples of the alkali metal include cesium, rubidium, and potassium. Among these, cesium is preferable.

As described above, the photoelectric conversion layer 14 may be a perovskite layer formed from a perovskite compound. A method for forming such a perovskite layer is not particularly limited and can be appropriately selected according to the purpose. Examples thereof include a method in which a solution in which a halogenated metal and a halogenated alkylamine are dissolved or dispersed is coated, followed by drying.

Examples of a method for forming the perovskite layer include a two-step precipitation method in which a solution in which a halogenated metal is dissolved or dispersed is coated and dried, and then immersed in a solution in which a halogenated alkylamine is dissolved to form a perovskite compound.

Other examples of the method for forming the perovskite layer include a method in which, during coating of a solution in which a halogenated metal and a halogenated alkylamine are dissolved or dispersed, a poor solvent (a solvent having low solubility) for the perovskite compound is added and crystals are precipitated.

Other examples of the method for forming the perovskite layer include a method in which a halogenated metal is subjected to vapor deposition in a gas filled with methylamine or the like.

Among the methods for forming the perovskite layer, preferable is the method in which a poor solvent for the perovskite compound is added during coating of a solution in which a halogenated metal and a halogenated alkylamine are dissolved or dispersed and crystals are precipitated. A method for coating these solutions is not particularly limited and can be appropriately selected according to the purpose. Examples thereof include an immersion method, a spin coating method, a spray method, a dip method, a roller method, and an air knife method. The method for coating the solution may also be, for example, a method of precipitating in a supercritical fluid using carbon dioxide or the like. In the above method in which a poor solvent is added and crystals are precipitated, examples of the poor solvent used include: hydrocarbons, such as n-hexane and n-octane; alcohols, such as methanol, ethanol, and 2-propanol; ethers, such as diethyl ether and diisopropyl ether; ketones, such as acetone and methyl isobutyl ketone; esters, such as ethyl acetate, isobutyl acetate, and γ-butyrolactone; nitriles, such as acetonitrile and 3-methoxypropionitrile; aromatic hydrocarbon compounds, such as benzene, toluene, and chlorobenzene; a halogenated solvent, such as dichloromethane and chloroform; and a fluorinated solvent, such as chlorofluorocarbon, hydrochlorofluorocarbon, and hydrofluorocarbon.

The thickness of the photoelectric conversion layer 14 (for example, a light absorption layer, for example, a perovskite layer) is not particularly limited, and is preferably 50 to 1200 nm, and more preferably 200 to 1000 nm, from the viewpoint of further suppressing performance degradation due to defects or separation.

An interface layer may be formed between the photoelectric conversion layer 14 and the electron transport layer 15. Since various crystal defects exist on a surface or a grain boundary of the photoelectric conversion layer 14, in order to passivate these defects, it is effective to provide a compound composed of an organic salt between the photoelectric conversion layer 14 and the electron transport layer 15. Specific examples of the organic salt include salt obtained from, as a cation, a monovalent or divalent cation formed by a reaction of an amino compound such as methylamine, n-butylamine, t-butylamine, n-hexyl-dimethylamine, pyridine, aniline, 2-phenylethylamine, 5-aminovaleric acid, ethylenediamine, morpholine, piperidine, or piperazine with a proton or the like, and an anion formed from a halogen such as fluorine, chlorine, bromine, or iodine, a carboxylic acid, sulfuric acid, nitric acid, phosphoric acid, oxalic acid, phthalic acid, succinic acid, thiocyanic acid, or isocyanic acid.

Since there is a possibility that the interface layer may become a resistance component if formed thick, it is preferable that the interface layer is formed thin. The formation method is not particularly limited, and examples thereof include formation by a spin coating method, an inkjet method, a cast method, or a spray coating method, using a solution in which the above-described salt is dissolved.

### [Electron Transport Layer]

A material used for the electron transport layer 15 is not particularly limited and can be appropriately selected according to the purpose, but a semiconductor material is preferable. The semiconductor material is not particularly limited and a known material may be used. Examples thereof include an elemental semiconductor, a compound semiconductor, and an organic n-type semiconductor.

The elemental semiconductor is not particularly limited, and examples thereof include silicon and germanium.

The compound semiconductor is not particularly limited, and examples thereof include a metal chalcogenide, specifically: an oxide of titanium, tin, zinc, iron, tungsten, zirconium, hafnium, strontium, indium, cerium, yttrium, lanthanum, vanadium, niobium, or tantalum; a sulfide of cadmium, zinc, lead, silver, antimony, or bismuth; a selenide of cadmium, or lead; and a telluride of cadmium. Other examples of the compound semiconductor include: a phosphide of zinc, gallium, indium, or cadmium; gallium arsenide; copper-indium-selenide; and copper-indium-sulfide.

The organic n-type semiconductor is not particularly limited, and examples thereof include perylene tetracarboxylic acid anhydride, a perylene tetracarboxydiimide compound, a naphthalenediimide-bithiophene copolymer, a benzobisimidazobenzophenanthroline polymer, a fullerene compound such as C₆₀, C₇₀, and PCBM ([6,6]-phenyl-C₆₁-butyric acid methyl ester), a carbonyl-bridged-bithiazole compound, Alq₃ (tris(8-quinolinolato)aluminum), a triphenylene bipyridyl compound, a silole compound, and an oxadiazole compound.

Among the above-described materials used for the electron transport layer 15, an organic n-type semiconductor is particularly preferable.

One type of the material used for forming the electron transport layer 15 may be used alone, or two or more types thereof may be used in combination. The crystal type of the semiconductor material is not particularly limited and can be appropriately selected according to the purpose. The semiconductor material may be a single crystal, a polycrystal, or an amorphous material.

A film thickness of the electron transport layer 15 is not particularly limited and can be appropriately selected according to the purpose, and is preferably 5 nm to 1000 nm, and more preferably 10 nm to 700 nm.

A method for forming the electron transport layer 15 is not particularly limited and can be appropriately selected according to the purpose. Examples thereof include a method (vacuum film formation method) for forming a thin film in a vacuum and a wet film formation method. Examples of the vacuum film formation method include a sputtering method, a pulsed laser deposition method (PLD method), an ion beam sputtering method, an ion assist method, an ion plating method, a vacuum deposition method, an atomic layer deposition method (ALD method), and a chemical vapor deposition method (CVD method). Examples of the wet film formation method include a method in which a film is formed by coating a solvent in which an electron transport material is dissolved, and, in the case of an oxide semiconductor, a sol-gel method. The sol-gel method is a method in which a gel is produced from a solution through chemical reactions such as hydrolysis and polymerization/condensation, and then densification is promoted by heat treatment. In the case of using the sol-gel method, a method for coating the sol solution is not particularly limited and can be appropriately selected according to the purpose. Examples thereof include a dip method, a spray method, a wire bar method, a spin coating method, a roller coating method, a blade coating method, a gravure coating method, and as a wet printing method, letterpress printing, offset printing, gravure printing, intaglio printing, rubber plate printing, and screen printing. The temperature during the heat treatment after coating of the sol solution is preferably 80 °C or higher, and more preferably 100 °C or higher.

After the electron transport layer 15 is formed, an electron injection layer (hole blocking layer) may be formed between the electron transport layer 15 and the second electrode 16. Examples of a material used for the electron injection layer include BCP (bathocuproine), and cesium may be doped therein. The electron injection layer preferably has a thickness of 1 to 100 nm, and more preferably 3 to 20 nm.

### [Second Electrode]

The second electrode 16 (which may be, for example, a back electrode) is a layer having a function of, for example, extracting electrons from the photoelectric conversion layer 14 via the electron transport layer. The second electrode 16 is, for example, a layer that functions as an anode (negative electrode).

The second electrode 16 may be formed directly on the electron transport layer (also referred to as an electron injection layer) 15. A material of the second electrode 16 is not particularly limited. For example, the same material as that of the first electrode 12 may be used. The shape, structure, and size of the second electrode 16 are not particularly limited and can be appropriately selected according to the purpose. Examples of the material of the second electrode 16 include a metal, a carbon compound, a conductive metal oxide, and a conductive polymer.

Examples of the metal include platinum, gold, silver, copper, and aluminum.

Examples of the carbon compounds include graphite, fullerene, carbon nanotubes, and graphene.

Examples of the conductive metal oxide include ITO, FTO, and ATO.

Examples of the conductive polymer include polythiophene and polyaniline.

One type of the material used for forming the second electrode 16 may be used alone, or two or more types thereof may be used in combination.

The second electrode 16 may be formed by appropriately using a method such as coating, lamination, vacuum deposition, CVD, and bonding on the electron transport layer 15, depending on the type of material used or the type of the hole transport layer 13.

In the photoelectric conversion element 10 of the present embodiment, at least one of the first electrode 12 and the second electrode 16 is preferably substantially transparent. In using the photoelectric conversion element 10 of the present embodiment, it is preferable to make an electrode transparent so that incident light enters from the electrode side. In this case, it is preferable to use a material that reflects light for a back electrode (electrode on the side opposite the transparent electrode, for example, the second electrode 16), and a metal, glass on which a conductive oxide is deposited, plastic, a metal thin film, or the like is preferably used. It is also an effective means to provide an anti-reflection layer on the electrode on the incident light side.

A configuration of the photoelectric conversion element 10 is not limited to the configuration of FIG. 1. For example, the support 11 may be disposed on a side (upper side of the second electrode 16 in FIG. 1) opposite that in FIG. 1. The second electrode 16, the electron transport layer 15, the photoelectric conversion layer 14, the hole transport layer 13, and the first electrode 12 may be laminated on the support 11 in the aforesaid order. For example, as described above, other components may or may not be present between each of the support 11, the first electrode 12, the hole transport layer 13, the photoelectric conversion layer 14, the electron transport layer 15, and the second electrode 16. Although an example has been described in which the first electrode 12 is a transparent electrode and the second electrode 16 is a back electrode, the photoelectric conversion element 10 is not limited thereto. For example, in the photoelectric conversion element 10, conversely, the first electrode 12 may be a back electrode and the second electrode 16 may be a transparent electrode.

### [Sealing]

The photoelectric conversion element 10 (for example, a solar cell) of the present embodiment is preferably sealed to protect the device (the photoelectric conversion element 10 of the present embodiment) from water or oxygen. The sealing structure is not particularly limited, and may be, for example, the same as a general photoelectric conversion element (for example, a solar cell). Specifically, for example, a sealing material may be applied to only an outer periphery of the photoelectric conversion element 10 of the present embodiment and covered with glass or a film, a sealing material may be applied to the entire surface of the photoelectric conversion element 10 of the present embodiment and covered with glass or a film, or a sealing material may be applied to only the entire surface of the photoelectric conversion element 10 of the present embodiment.

A material of a sealing member is not particularly limited and can be appropriately selected according to the purpose. For example, an epoxy resin or an acrylic resin is preferably used and cured, but the material may be uncured or only partially cured.

The epoxy resin is not particularly limited, and examples thereof include water-dispersed type, solvent-free type, solid type, heat-curable type, curing agent-mixed type, and ultraviolet-curable type. Among these, the heat-curable type and the ultraviolet-curable type are preferable, and the ultraviolet-curable type is more preferable. Even in the case of the ultraviolet-curable type, heating may be performed, and it is preferable to perform heating even after ultraviolet curing. Specific examples of the epoxy resin include bisphenol A type, bisphenol F type, novolac type, cycloaliphatic type, long-chain aliphatic type, glycidylamine type, glycidyl ether type, and glycidyl ester type, and these may be used alone or in combination of two or more. It is preferable to mix a curing agent or various additives into the epoxy resin as needed. Epoxy resin compositions that are already commercially available can be used in the present embodiment. Among them, there are epoxy resin compositions that have been developed and are commercially available for solar cell or organic EL element applications, and these can be particularly effectively used in the present embodiment. Examples of commercially available epoxy resin compositions include TB3118, TB3114, TB3124, and TB3125F (manufactured by ThreeBond Co., Ltd.), World Rock 5910, World Rock 5920, and World Rock 8723 (manufactured by Kyoritsu Chemical Industry Co., Ltd.), WB90US(P), and WB90US-HV (manufactured by MORESCO Corporation).

The acrylic resin is not particularly limited. For example, those that have been developed and are commercially available for solar cell or organic EL element applications can be effectively used. Examples of commercially available acrylic resin compositions include TB3035B and TB3035C (manufactured by ThreeBond Co., Ltd.).

The curing agent is not particularly limited and can be appropriately selected according to the purpose. Examples thereof include amine-based, acid anhydride-based, polyamide-based, and other curing agents. Examples of amine-based curing agents include: aliphatic polyamine, such as diethylenetriamine and triethylenetetramine; and aromatic polyamine, such as metaphenylenediamine, diaminodiphenylmethane, and diaminodiphenylsulfone. Examples of acid anhydride-based curing agents include phthalic anhydride, tetra- and hexahydrophthalic anhydride, methyltetrahydrophthalic anhydride, methyl nadic anhydride, pyromellitic anhydride, het anhydride, and dodecenyl succinic anhydride. Examples of other curing agents include imidazoles and polymercaptan. These may be used alone or in combination of two or more.

The additive is not particularly limited and can be appropriately selected according to the purpose. Examples thereof include a filler, a gap agent, a polymerization initiator, a desiccant (moisture absorbent), a curing accelerator, a coupling agent, a flexibilizer, a colorant, a flame retardant aid, an antioxidant, and an organic solvent. Among these, a filler, a gap agent, a curing accelerator, a polymerization initiator, and a desiccants (moisture absorbent) are preferable, and a filler and a polymerization initiator are more preferable. By including a filler as an additive, effects such as suppression of intrusion of moisture and oxygen, reduction of volume shrinkage during curing, reduction of outgas during curing or heating, improvement of mechanical strength, and control of thermal conductivity and fluidity can be achieved. Hence, including a filler as an additive is highly effective in maintaining stable output in various environments.

Regarding the output characteristics and durability of the photoelectric conversion element, in addition to the influence of moisture and oxygen that intrude, the influence of outgas generated during curing or heating of the sealing member cannot be ignored. In particular, the influence of outgas generated during heating has a considerable impact on the output characteristics in storage in a high-temperature environment. By incorporating a filler, a gap agent, and a desiccant into the sealing member, these components themselves may suppress the intrusion of moisture and oxygen. In addition, by reducing the amount of the sealing member used, the effect of reducing outgas can be achieved. Incorporating a filler, a gap agent, and a desiccant into the sealing member is effective not only during curing but also in storing the photoelectric conversion element in a high-temperature environment.

The filler is not particularly limited and can be appropriately selected according to the purpose. Examples thereof include an inorganic filler such as crystalline or amorphous silica, silicate mineral such as talc, alumina, aluminum nitride, silicon nitride, calcium silicate, and calcium carbonate. Among these, hydrotalcite is particularly preferable. These may be used alone or in combination of two or more.

An average primary particle size of the filler is not particularly limited, and is preferably 0.1 µm or more and 10 µm or less, and more preferably 1 µm or more and 5 µm or less. In the case where the average primary particle size of the filler is within the preferable range described above, the effect of suppressing the intrusion of moisture and oxygen can be sufficiently achieved, the viscosity becomes appropriate, the adhesion to the substrate and defoaming properties are improved, and effects are also exhibited in controlling a width of a sealing portion and in workability.

The content of the filler is preferably 10 parts by mass or more and 90 parts by mass or less, and more preferably 20 parts by mass or more and 70 parts by mass or less, relative to the entire sealing member (100 parts by mass). In the case where the content of the filler is within the preferable range described above, the effect of suppressing the intrusion of moisture and oxygen can be sufficiently achieved, the viscosity becomes appropriate, and the adhesion and workability are also improved.

The gap agent is also referred to as a gap control agent or a spacer agent. By including a gap agent as an additive, it is possible to control a gap of the sealing portion. For example, in the case where the sealing member is applied onto a first substrate or a first electrode, and a second substrate is placed thereon to perform sealing, by mixing the gap agent into the sealing member, the gap of the sealing portion is aligned with the size of the gap agent, thereby making it easy to control the gap of the sealing portion.

The gap agent is not particularly limited. For example, one that is granular, has a uniform particle size, and has high solvent resistance or heat resistance is preferable, and can be appropriately selected according to the purpose. As the gap agent, those having high affinity with epoxy resin and a spherical particle shape are preferable. Specifically, glass beads, silica fine particles, and organic resin fine particles are preferable. These may be used alone or in combination of two or more. The particle size of the gap agent may be selected in accordance with the gap of the sealing portion to be set, and is preferably 1 µm or more and 100 µm or less, and more preferably 5 µm or more and 50 µm or less.

The polymerization initiator is not particularly limited, and examples thereof include a polymerization initiator that initiates polymerization using heat or light, which can be appropriately selected according to the purpose. Examples thereof include a thermal polymerization initiator and a photopolymerization initiator. A thermal polymerization initiator is a compound that generates active species such as radicals and cations by heating, and examples thereof include an azo compound such as 2,2'-azobisisobutyronitrile (AIBN) and a peroxide such as benzoyl peroxide (BPO). As a thermal cationic polymerization initiator, a benzenesulfonic acid ester, alkylsulfonium salt, or the like may be used. For the photopolymerization initiator, a photocationic polymerization initiator is preferably used in the case of epoxy resin. When a photocationic polymerization initiator is mixed in epoxy resin and light irradiation is performed, the photocationic polymerization initiator decomposes to generate an acid, the acid causes polymerization of the epoxy resin, and a curing reaction proceeds. The photocationic polymerization initiator has effects such as low volume shrinkage during curing, no oxygen inhibition, and high storage stability.

Examples of the photocationic polymerization initiator include aromatic diazonium salt, aromatic iodonium salt, aromatic sulfonium salt, a metacerone compound, and a silanol-aluminum complex. A photoacid generator having a function of generating an acid by light irradiation may also be used as a polymerization initiator. The photoacid generator acts as an acid that initiates cationic polymerization, and examples thereof include onium salts such as ionic sulfonium salts and iodonium salts including a cationic portion and an anionic portion. These may be used alone or in combination of two or more.

The amount of the polymerization initiator added is not particularly limited and may vary depending on the material used, and is preferably 0.5 part by mass or more and 10 parts by mass or less, and more preferably 1 part by mass or more and 5 parts by mass or less, relative to the entire sealing member (100 parts by mass). In the case where the amount added is within the preferable range described above, curing proceeds appropriately, residual uncured material can be reduced, and excessive outgassing can be prevented.

The desiccant (also referred to as a moisture absorbent) is a material having a function of physically or chemically adsorbing and absorbing moisture. By incorporating the desiccant into the sealing member, moisture resistance can be further enhanced and the influence of outgassing can be reduced. The desiccant is not particularly limited and can be appropriately selected according to the purpose, and one in particulate form is preferable. Examples thereof include an inorganic water-absorbing material such as calcium oxide, barium oxide, magnesium oxide, magnesium sulfate, sodium sulfate, calcium chloride, silica gel, molecular sieve, and zeolite. Among these, zeolite, which has a high moisture absorption capacity, is preferable. These may be used alone or in combination of two or more.

The curing accelerator (also referred to as curing catalyst) is a material that accelerates a curing rate, and is used primarily in thermosetting epoxy resins. The curing accelerator is not particularly limited and can be appropriately selected according to the purpose. Examples thereof include: tertiary amine or tertiary amine salt, such as DBU (1,8-diazabicyclo(5,4,0)-undecene-7) and DBN (1,5-diazabicyclo(4,3,0)-nonene-5); an imidazole-based curing accelerator, such as 1-cyanoethyl-2-ethyl-4-methylimidazole and 2-ethyl-4-methylimidazole; and phosphine or phosphonium salt, such as triphenylphosphine and tetraphenylphosphonium tetraphenylborate. These may be used alone or in combination of two or more.

The coupling agent is not particularly limited if it is a material having an effect of enhancing molecular bonding force, and can be appropriately selected according to the purpose. Examples thereof include a silane coupling agent. Specific examples thereof include a silane coupling agent such as 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, and 3-methacryloxypropyltrimethoxysilane. These may be used alone or in combination of two or more.

In the present embodiment, for example, a sheet-shaped adhesive may be used. The sheet-shaped adhesive is, for example, one in which a resin layer is formed in advance on a sheet using a sealing resin. For the sheet, glass, a film having high gas barrier properties or the like may be used. The sheet-shaped adhesive may be formed using only the sealing resin. It is also possible to attach the sheet-shaped adhesive onto a sealing film. In this case, it is also possible to provide a hollow portion in a sheet constituting the sheet-shaped adhesive attached onto the sealing film, and then bond the sheet-shaped adhesive to a device.

In the case of sealing using the sealing film, the sealing film is disposed facing a support so as to sandwich a photoelectric conversion device. The shape, structure, size, and type of a base material of the sealing film are not particularly limited and can be appropriately selected according to the purpose. The sealing film has a barrier layer that prevents passage of moisture and oxygen formed on a surface of the base material, and the barrier layer may be formed on only one side or on both sides of the base material.

The barrier layer may be composed of a material containing, as a main component, for example, a metal oxide, a metal, or a mixture formed from a polymer and a metal alkoxide. Examples of the metal oxide include aluminum oxide, silicon oxide, and aluminum. Examples of the polymer include polyvinyl alcohol, polyvinylpyrrolidone, and methylcellulose. Examples of the metal alkoxide include tetraethoxysilane, triisopropoxyaluminum, 3-glycidoxypropyltrimethoxysilane, 3-mercaptopropyltrimethoxysilane, and 3-isocyanatepropyltriethoxysilane.

The barrier layer may be, for example, either transparent or opaque. The barrier layer may be a single layer formed by a combination of the above materials or may have a multilayer laminated structure. A known method may be used as a method for forming the barrier layer, and a coating method, such as vacuum film formation such as a sputtering method, a dipping method, a roll coating method, a screen printing method, a spray method, and a gravure printing method may be used.

### [Wiring]

In the photoelectric conversion element 10 (for example, a solar cell) of the present embodiment, in order to efficiently extract a current generated by light, it is preferable to connect a lead wire (wiring) to the first electrode 12 and a second electrode back electrode. The lead wire is connected to, for example, the first electrode and the second electrode using a conductive material such as solder, silver paste, or graphite. The conductive material may be used alone or as a mixture or laminated structure of two or more types. A portion to which the lead wire is attached may be covered with acrylic resin or epoxy resin from the viewpoint of physical protection.

Lead wire is a general term for electric wires for electrically connecting power sources, electronic components, and the like in an electric circuit, and examples thereof include a vinyl wire and an enamel wire.

The photoelectric conversion element 10 described above has excellent photoelectric conversion characteristics and is improved in durability.

### [Application]

The application and usage of the photoelectric conversion element 10 of the present embodiment are not particularly limited, and the photoelectric conversion element 10 can be widely used in the same applications as those of a general photoelectric conversion element (for example, general solar cell). The photoelectric conversion element (for example, a solar cell) of the present embodiment can be applied to a power supply device by, for example, being combined with a circuit board or the like that controls a generated current. Examples of devices utilizing the power supply device include an electronic desktop calculator and a solar radio-controlled wristwatch. The solar cell of the present embodiment may be applied as a power supply device to a mobile phone, an electronic paper, a thermo-hygrometer, or the like. The solar cell may be applied as an auxiliary power source for extending the continuous use time of a rechargeable or dry-cell electric appliance, or may be applied for nighttime use or the like by being combined with a secondary battery. The solar cell may be used as a self-sustaining power source that does not require battery replacement or power supply wiring.

### [Solar Cell Module]

A solar cell module according to an embodiment includes the photoelectric conversion element 10 of the above-described form. A specific configuration of the solar cell module will be described in the examples.

The embodiments of the present invention have been described above, but these are examples of the present invention, and various configurations other than those described above may be adopted.

In the photoelectric conversion element 10, an intermediate layer may be formed between the first electrode 12 and the hole transport layer 13. The intermediate layer preferably uses, for example, a single or mixed oxide formed from oxides of nickel, copper, or aluminum as a p-type metal oxide semiconductor. The intermediate layer is preferably formed of nickel oxide (NiO).

A film thickness of the intermediate layer is preferably 1 to 1000 nm, and more preferably 10 to 500 nm. A method for forming the intermediate layer including nickel oxide (NiO) as a p-type metal oxide semiconductor is not particularly limited, and may be either vacuum film formation such as sputtering or ion plating, or wet film formation such as sol-gel. An average particle size of nickel oxide fine particles is, for example, 0.2 to 60.0 nm, preferably 1.0 to 30.0 nm, more preferably 1.0 to 10.0 nm, and even more preferably 2.0 to 3.5 nm.

By forming the intermediate layer made of a p-type metal oxide semiconductor, it is possible to improve the durability of the photoelectric conversion element while maintaining the photoelectric conversion characteristics without impairing the characteristics of the hole transport layer 13 and the insulating compound.

### Examples

Hereinafter, examples of the present invention will be described. However, the present invention is not limited to the following examples.

### [Example 1]

A solar cell as a photoelectric conversion element was fabricated (produced) in the following manner (film formation procedure 1).

On the ITO of an ITO glass substrate (a glass substrate as a support on which a first electrode was formed, 25 mm square size), 1 mL of a DMF solution in which (A-06) (0.1 mmol/L) was dissolved was placed, and a monolayer (hole transporter in the hole transport layer) was formed on the ITO (first electrode) using a spin coater (3,000 rpm, 30 seconds) and a hot plate (110 °C, 10 minutes).

Next, 0.1 mL of a solution prepared by diluting an alumina dispersion (a dispersion having an average particle size of alumina of 50 nm, an alumina content of 20 wt%, and 2-propanol as a dispersion medium) 50-fold with 2-propanol was added onto the hole transporter, and a hole transport layer was formed from a material in which a hole transport material and an insulating compound were mixed, using a spin coater (3,000 rpm, 30 seconds) and a hot plate (100 °C, 15 minutes).

Next, a solution prepared by dissolving cesium iodide (0.738 g), formamidinium iodide (7.512 g), methylamine bromide (0.905 g), lead iodide (23.888 g), and lead bromide (1.022 g) in DMF (40.0 mL) and dimethyl sulfoxide (DMSO, 12.0 mL) was formed into a film on the substrate using spin coating. The spin coating was performed at 3,000 rpm, and chlorobenzene (0.3 mL) was added dropwise 30 seconds after the start. Thereafter, heating was performed at 150 °C for 10 minutes to obtain a perovskite layer (photoelectric conversion layer). Subsequently, ethylenediamine dihydroiodide at 0.5 nm (interface layer), C₆₀ at 20 nm (electron transport layer), bathocuproine (BCP, 8 nm) (electron injection layer), and Ag (100 nm) (second electrode) were formed into films by vacuum deposition to fabricate a photoelectric conversion element. After fabrication, the solar cell characteristics of the photoelectric conversion element of 25 mm square size were evaluated.

In order to evaluate variation, 10 solar cells were fabricated under the same conditions, and the solar cell characteristics were evaluated. Table 1 shows best data (most favorable values), average values, and standard deviations among the 10 fabricated samples (this also applies to the following examples and comparative examples).

The photoelectric conversion characteristics of the photoelectric conversion element fabricated in Example 1 were measured by a method conforming to the output measurement method for crystalline silicon solar cells of JIS C8913:1998. A solar simulator (SMO-250III type, manufactured by Bunkoukeiki Co., Ltd.) combined with an air mass filter equivalent to AM1.5G was adjusted to a light intensity of 100 mW/cm² using a secondary reference Si solar cell to serve as a measurement light source. While light is irradiated onto a test sample (the photoelectric conversion element fabricated in Example 1) of a perovskite solar cell, I-V curve characteristics were measured using a source meter (Model 2400 general-purpose source meter, manufactured by Keithley Instruments Inc.), and a short-circuit current (Isc), an open-circuit voltage (Voc), a fill factor (FF), a short-circuit current density (Jsc), and a photoelectric conversion efficiency (PCE) were obtained from the I-V curve characteristics measurement.

The solar cell characteristics were evaluated in the same manner in the following examples and comparative examples. 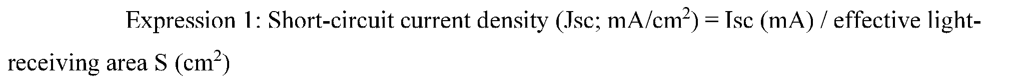 Short-circuit current density (Jsc; mA/cm2) = Isc (mA) / effective light-receiving area S (cm2) 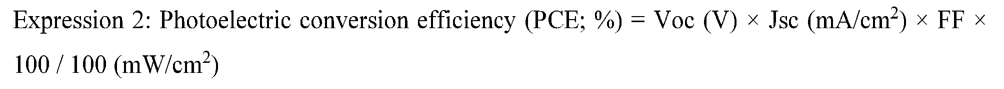 Photoelectric conversion efficiency (PCE; %) = Voc (V) × Jsc (mA/cm2) × FF × 100 / 100 (mW/cm2)

### [Example 2]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution obtained by diluting an alumina dispersion (a dispersion having an average particle size of alumina of 50 nm, an alumina content of 20 wt%, and 2-propanol as a dispersion medium) 30-fold with 2-propanol. The results of the solar cell characteristics are shown in Table 1 below.

### [Example 3]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution obtained by diluting an alumina dispersion (a dispersion having an average particle size of alumina of 50 nm, an alumina content of 20 wt%, and 2-propanol as a dispersion medium) 100-fold with 2-propanol. The results of the solar cell characteristics are shown in Table 1 below.

### [Example 4]

A photoelectric conversion element was fabricated (produced) and the photoelectric conversion efficiency was measured in the same manner as in Example 1, except that the DMF solution in which (A-06) (0.1 mmol/L) was dissolved in Example 1 was changed to a DMF solution in which (A-15) (0.1 mmol/L) was dissolved. The results of the solar cell characteristics are shown in Table 1 below.

### [Example 5]

A photoelectric conversion element was fabricated (produced) and the photoelectric conversion efficiency was measured in the same manner as in Example 1, except that the DMF solution in which (A-06) (0.1 mmol/L) was dissolved in Example 1 was changed to a DMF solution in which (A-16) (0.1 mmol/L) was dissolved. The results of the solar cell characteristics are shown in Table 1 below.

### [Example 6]

A photoelectric conversion element was fabricated (produced) and the photoelectric conversion efficiency was measured in the same manner as in Example 1, except that the DMF solution in which (A-06) (0.1 mmol/L) was dissolved in Example 1 was changed to a DMF solution in which (A-06) (0.1 mmol/L) and 4-hydroxyphenylphosphonic acid (0.2 mmol/L) were dissolved. The results of the solar cell characteristics are shown in Table 1 below.

### [Example 7]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution prepared by diluting a silica dispersion (a dispersion having an average particle size of silica of 150 nm, a silica content of 5 wt%, and ethanol as a dispersion medium) 8-fold with 2-propanol. The results of the solar cell characteristics are shown in Table 1 below.

### [Example 8]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution prepared by diluting a ceria dispersion (a dispersion having an average particle size of ceria of 50 nm, a ceria content of 20 wt%, and a 2.5 wt% aqueous acetic acid solution as a dispersion medium) 50-fold with 2-propanol. The results of the solar cell characteristics are shown in Table 1 below.

### [Example 9]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution prepared by diluting a yttria dispersion (a dispersion having an average particle size of yttria of 100 nm, a yttria content of 10 wt%, and 2-propanol as a dispersion medium) 25-fold with 2-propanol. The results of the solar cell characteristics are shown in Table 1 below.

### [Example 10]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution prepared by diluting a barium titanate dispersion (a dispersion having an average particle size of barium titanate of 50 nm, a barium titanate content of 5 wt%, and 2-propanol as a dispersion medium) 12.5-fold with 2-propanol. The results of the solar cell characteristics are shown in Table 1 below.

### [Example 11]

A solar cell as a photoelectric conversion element was fabricated (produced) in the following manner (film formation procedure 2).

On the ITO of an ITO glass substrate (a glass substrate as a support on which a first electrode was formed, 25 mm square size), 0.1 mL of a solution prepared by diluting an alumina dispersion (a dispersion having an average particle size of alumina of 50 nm, an alumina content of 20 wt%, and 2-propanol as a dispersion medium) 50-fold with 2-propanol was placed, processed with a spin coater (3,000 rpm, 30 seconds), and then dried on a hot plate (100 °C, 15 minutes). Subsequently, 1 mL of a DMF solution in which (A-06) (0.1 mmol/L) was dissolved was placed, and a hole transport layer was formed using a spin coater (3,000 rpm, 30 seconds) and a hot plate (110 °C, 10 minutes). Next, a solution prepared by dissolving cesium iodide (0.738 g), formamidinium iodide (7.512 g), methylamine bromide (0.905 g), lead iodide (23.888 g), and lead bromide (1.022 g) in DMF (40.0 mL) and dimethyl sulfoxide (DMSO, 12.0 mL) was formed into a film on the substrate using spin coating. The spin coating was performed at 3,000 rpm, and chlorobenzene (0.3 mL) was added dropwise 30 seconds after the start. Thereafter, heating was performed at 150 °C for 10 minutes to obtain a perovskite layer (photoelectric conversion layer). Subsequently, ethylenediamine dihydroiodide at 0.5 nm (interface layer), C₆₀ at 20 nm (electron transport layer), bathocuproine (BCP, 8 nm) (electron injection layer), and Ag (100 nm) (second electrode) were formed into films by vacuum deposition to fabricate a photoelectric conversion element. After fabrication, the solar cell characteristics of the photoelectric conversion element of 25 mm square size were evaluated. The performance thereof is shown in Table 1.

### [Example 12]

A photoelectric conversion element was fabricated (produced) and the photoelectric conversion efficiency was measured in the same manner as in Example 11, except that the solution prepared by diluting an alumina dispersion (a dispersion having an average particle size of alumina of 50 nm, an alumina content of 20 wt%, and 2-propanol as a dispersion medium) in Example 11 50-fold with 2-propanol was changed to a solution prepared by diluting a silica dispersion (a dispersion having an average particle size of silica of 150 nm, a silica content of 5 wt%, and ethanol as a dispersion medium) 8-fold with 2-propanol. The results of the solar cell characteristics are shown in Table 1 below.

### [Example 13]

A solar cell as a photoelectric conversion element was fabricated (produced) in the following manner (film formation procedure 3).

On the ITO of an ITO glass substrate (a glass substrate as a support on which a first electrode was formed, 25 mm square size), 1 mL of a solution prepared by mixing, at a volume ratio of 1:1, a solution prepared by diluting an alumina dispersion (a dispersion having an average particle size of alumina of 50 nm, an alumina content of 20 wt%, and 2-propanol as a dispersion medium) 50-fold with DMF and a DMF solution in which (A-15) (0.1 mmol/L) was dissolved was placed, and a hole transport layer was formed using a spin coater (3,000 rpm, 30 seconds) and a hot plate (100 °C, 10 minutes). Next, a solution prepared by dissolving cesium iodide (0.738 g), formamidinium iodide (7.512 g), methylamine bromide (0.905 g), lead iodide (23.888 g), and lead bromide (1.022 g) in DMF (40.0 mL) and dimethyl sulfoxide (DMSO, 12.0 mL) was formed into a film on the substrate using spin coating. The spin coating was performed at 3,000 rpm, and chlorobenzene (0.3 mL) was added dropwise 30 seconds after the start. Thereafter, heating was performed at 150 °C for 10 minutes to obtain a perovskite layer (photoelectric conversion layer). Subsequently, ethylenediamine dihydroiodide at 0.5 nm (interface layer), C₆₀ at 20 nm (electron transport layer), bathocuproine (BCP, 8 nm) (electron injection layer), and Ag (100 nm) (second electrode) were formed into films by vacuum deposition to fabricate a photoelectric conversion element. After fabrication, the solar cell characteristics of the photoelectric conversion element of 25 mm square size were evaluated. The performance thereof is shown in Table 1.

### [Example 14]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution prepared by mixing, at a mass ratio of 1:1, a solution prepared by diluting an alumina dispersion (a dispersion having an average particle size of alumina of 50 nm, an alumina content of 20 wt%, and 2-propanol as a dispersion medium) 50-fold with 2-propanol and a solution prepared by diluting a silica dispersion (a dispersion having an average particle size of silica of 150 nm, a silica content of 5 wt%, and ethanol as a dispersion medium) 8-fold with 2-propanol. The results of the solar cell characteristics are shown in Table 1 below.

### [Example 15]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution prepared by mixing, at a volume ratio of 1:1, a solution prepared by diluting an alumina dispersion (a dispersion having an average particle size of alumina of 50 nm, an alumina content of 20 wt%, and 2-propanol as a dispersion medium) 50-fold with 2-propanol and a solution prepared by diluting a yttria dispersion (a dispersion having an average particle size of yttria of 100 nm, a yttria content of 10 wt%, and 2-propanol as a dispersion medium) 25-fold with 2-propanol. The results of the solar cell characteristics are shown in Table 1 below.

### [Comparative Example 1]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was not used. The results of the solar cell characteristics are shown in Table 1 below.

### [Comparative Example 2]

A photoelectric conversion element was fabricated (produced) and the photoelectric conversion efficiency was measured in the same manner as in Example 1, except that the solution prepared by diluting an alumina dispersion (a dispersion having an average particle size of alumina of 50 nm, an alumina content of 20 wt%, and 2-propanol as a dispersion medium) as the insulating compound in Example 1 50-fold with 2-propanol was changed to a solution prepared by diluting an aluminum-doped zinc oxide dispersion (a dispersion having an average particle size of aluminum-doped zinc oxide (also referred to as AZO) of 16 nm, an AZO content of 2.5 wt%, and 2-propanol as a dispersion medium) 6.25-fold with 2-propanol. The results of the solar cell characteristics are shown in Table 1 below.

### [Comparative Example 3]

A photoelectric conversion element was fabricated (produced) and the photoelectric conversion efficiency was measured in the same manner as in Example 11, except that the solution prepared by diluting an alumina dispersion (a dispersion having an average particle size of alumina of 50 nm, an alumina content of 20 wt%, and 2-propanol as a dispersion medium) as the insulating compound in Example 11 50-fold with 2-propanol was changed to a solution prepared by diluting an aluminum-doped zinc oxide dispersion (a dispersion having an average particle size of AZO of 16 nm, an AZO content of 2.5 wt%, and 2-propanol as a dispersion medium) 6.25-fold with 2-propanol. The results of the solar cell characteristics are shown in Table 1 below.

### [Comparative Example 4]

A photoelectric conversion element was fabricated (produced) and the photoelectric conversion efficiency was measured in the same manner as in Example 13, except that the solution prepared by diluting an alumina dispersion (a dispersion having an average particle size of alumina of 50 nm, an alumina content of 20 wt%, and 2-propanol as a dispersion medium) as the insulating compound in Example 13 50-fold with DMF was changed to a solution prepared by diluting an aluminum-doped zinc oxide dispersion (a dispersion having an average particle size of AZO of 16 nm, an AZO content of 2.5 wt%, and 2-propanol as a dispersion medium) 6.25-fold with DMF. The results of the solar cell characteristics are shown in Table 1 below.

**[Table 1]**

| | Monomolecular hole transport material | Co-adsorbent | Insulating compound | Concentration of insulating compound | Film formation procedure | Solar cell characteristics (best data) | | | | Avg. | Standard deviation σ |
|---|---|---|---|---|---|---|---|---|---|---|---|
| | | | | | | Voc (V) | Jsc (mA/cm²) | FF | PCE (%) | PCE (%) | |
| Example 1 | A-06 | None | Al₂O₃ (50 nm) | 0.4 wt% | 1 | 1.13 | 23.9 | 81.1 | 21.9 | 21.2 | 0.48 |
| Example 2 | A-06 | None | Al₂O₃ (50 nm) | 0.67 wt% | 1 | 1.11 | 23.8 | 79.8 | 21.1 | 20.3 | 0.51 |
| Example 3 | A-06 | None | Al₂O₃ (50 nm) | 0.2 wt% | 1 | 1.08 | 23.8 | 77.9 | 20.0 | 18.3 | 0.56 |
| Example 4 | A-15 | None | Al₂O₃ (50 nm) | 0.4 wt% | 1 | 1.12 | 24.1 | 78.5 | 21.2 | 20.4 | 0.51 |
| Example 5 | A-16 | None | Al₂O₃ (50 nm) | 0.4 wt% | 1 | 1.11 | 24.0 | 79.1 | 21.1 | 20.3 | 0.58 |
| Example 6 | A-16 | 4-hydroxyphenylphosphonic acid | Al₂O₃ (50 nm) | 0.4 wt% | 1 | 1.15 | 23.7 | 80.6 | 22.0 | 21.4 | 0.47 |
| Example 7 | A-06 | None | SiO₂ (150 nm) | 0.625 wt% | 1 | 1.12 | 23.6 | 80.9 | 21.4 | 20.4 | 0.66 |
| Example 8 | A-06 | None | CeO₂ (50 nm) | 0.4 wt% | 1 | 1.11 | 23.1 | 80.4 | 20.6 | 19.8 | 0.48 |
| Example 9 | A-06 | None | Y₂O₅ (100 nm) | 0.4 wt% | 1 | 1.09 | 24.1 | 79.4 | 20.9 | 19.9 | 0.60 |
| Example 10 | A-06 | None | BaTiO₃ (50 nm) | 0.4 wt% | 1 | 1.07 | 23.9 | 78.8 20.2 | | 19.1 | 0.66 |
| Example 11 | A-06 | None | Al₂O₃ (50 nm) | 0.4 wt% | 2 | 1.06 | 23.5 | 77.9 | 19.4 | 18.6 | 0.49 |
| Example 12 | A-06 | None | SiO₂ (150 nm) | 0.625 wt% | 2 | 1.05 | 23.6 | 77.5 | 19.2 | 18.6 | 0.48 |
| Example 13 | A-15 | None | Al₂O₃ (50 nm) | 0.4 wt% | 3 | 1.02 | 23.3 | 77.8 | 18.5 | 18.0 | 0.39 |
| Example 14 | A-06 | None | Al₂O₃ (50 nm)+ SiO₂ (150 nm) | 0.51 wt% | 1 | 1.12 | 24.1 | 80.7' | 21.8 | 20.9 | 0.58 |
| Example 15 | A-15 | None | Al₂O₃ (50 nm)+ Y₂O₅ (100 nm) | 0.4 wt% | 1 | 1.13 | 23.7 | 81.1 | 21.7 | 20.8 | 0.60 |
| Comparative Example 1 | A-06 | None | None | - | 1 | 1.07 | 20.8 | 78.9 | 17.6 | 15.8 | 1.32 |
| Comparative Example 2 | A-06 | None | AZO | 0.4 wt% | 1 | 0.44 | 18.3 | 26.7 | 2.1 | 0.8 | 0.68 |
| Comparative Example 3 | A-15 | None | AZO | 0.4 wt% | 2 | 0.82 | 17.9 | 47.2 | 6.9 | 2.8 | 2.24 |
| Comparative Example 4 | A-15 | None | AZO | 0.4 wt% | 3 | 0.79 | 9.3 | 24.8 | 1.8 | 1.0 | 0.54 |

According to Table 1, from a comparison between Example 1 and Comparative Example 1, it is known that by using a material in which a hole transport material and an insulating compound are mixed in a hole transport layer, the short-circuit current density (Jsc) in particular increases, and high efficiency is achieved. According to Examples 1 to 3, it is clear that high efficiency is achieved even if the concentration of the insulating compound varies. According to Examples 7 to 10, it is clear that a high-efficiency solar cell can be provided even with different types of insulating compounds. According to Examples 1 and 4 to 5, it is clear that even with different types of hole transport materials, a high-output solar cell can be provided when the hole transport material is combined with the insulating compound.

According to Examples 1 and 11 to 13, it is clear that high output can be achieved even if the film formation method is changed. According to Example 1 and Comparative Example 2, Example 11 and Comparative Example 3, and Example 13 and Comparative Example 4, it is known that a high-output solar cell can be achieved in the case where the material combined with the hole transport material is an insulating compound, but only low efficiency can be provided when the hole transport material is combined with a conductive compound (AZO having a resistance value of generally 10⁻³ Ω/□). It is clear that not only the level of solar cell characteristics but also the variation (standard deviation) in solar cell characteristics obtained in fabricating 10 solar cells demonstrates that the aspects of the present invention excel in effect.

### [Example 16]

On the ITO of an ITO glass substrate (a glass substrate as a support on which a first electrode was formed, 25 mm square size), nickel oxide (NiO) was formed into a film to a thickness of 15 nm by sputtering. Subsequently, 1 mL of a DMF solution in which (A-06) (0.1 mmol/L) was dissolved was placed, and a monolayer (hole transport layer) was formed on the NiO using a spin coater (3,000 rpm, 30 seconds) and a hot plate (110 °C, 10 minutes). Next, by using a solution prepared by diluting an alumina dispersion (Sigma-Aldrich, 702129, 50 nm, 20 wt%, 2-propanol dispersion) 50-fold with 2-propanol with a spin coater (3,000 rpm, 30 seconds) and a hot plate (100 °C, 15 minutes), a hole transport layer was formed. Next, a solution prepared by dissolving cesium iodide (0.738 g), formamidinium iodide (7.512 g), methylamine bromide (0.905 g), lead iodide (23.888 g), and lead bromide (1.022 g) in DMF (40.0 mL) and dimethyl sulfoxide (DMSO, 12.0 mL) was formed into a film on the substrate using spin coating. The spin coating was performed at 3,000 rpm, and chlorobenzene (0.3 mL) was added dropwise 30 seconds after the start. Thereafter, heating was performed at 150 °C for 10 minutes to obtain a perovskite layer (photoelectric conversion layer). Subsequently, ethylenediamine dihydroiodide at 0.5 nm (interface layer), C₆₀ at 20 nm (electron transport layer), bathocuproine (BCP, 8 nm) (electron injection layer), and Ag (100 nm) (second electrode) were formed into films by vacuum deposition to fabricate a photoelectric conversion element. After fabrication, the solar cell characteristics of the photoelectric conversion element of 25 mm square size were evaluated. The performance thereof is shown in Table 1. In order to evaluate variation, 10 solar cells were fabricated under the same conditions, the solar cell characteristics were evaluated, and the average values and standard deviations were evaluated. These values are shown in Table 2.

### [Example 17]

A photoelectric conversion element was fabricated (produced) and the photoelectric conversion efficiency was measured in the same manner as in Example 16, except that the NiO (15 nm film thickness) in Example 16 was changed to NiO (25 nm film thickness). The results of the solar cell characteristics are shown in Table 2 below.

### [Example 18]

A photoelectric conversion element was fabricated (produced) and the photoelectric conversion efficiency was measured in the same manner as in Example 16, except that the NiO (15 nm film thickness) in Example 16 was changed to NiO (50 nm film thickness). The results of the solar cell characteristics are shown in Table 2 below.

### [Example 19]

A photoelectric conversion element was fabricated (produced) and the photoelectric conversion efficiency was measured in the same manner as in Example 16, except that the NiO (15 nm film thickness) in Example 16 was changed to NiO (70 nm film thickness). The results of the solar cell characteristics are shown in Table 2 below.

### [Example 20]

A photoelectric conversion element was fabricated (produced) and the photoelectric conversion efficiency was measured in the same manner as in Example 16, except that the NiO (15 nm film thickness) in Example 16 was changed to CuAlO₂ (15 nm film thickness). The results of the solar cell characteristics are shown in Table 2 below.

### [Example 21]

A photoelectric conversion element was fabricated (produced) and the photoelectric conversion efficiency was measured in the same manner as in Example 16, except that the NiO (15 nm film thickness) in Example 16 was changed to CuAlO₂ (30 nm film thickness). The results of the solar cell characteristics are shown in Table 2 below.

### [Example 22]

A photoelectric conversion element was fabricated (produced) and the photoelectric conversion efficiency was measured in the same manner as in Example 16, except that the NiO (15 nm film thickness) in Example 16 was changed to CuAlO₂ (50 nm film thickness). The results of the solar cell characteristics are shown in Table 2 below.

### [Example 23]

A photoelectric conversion element was fabricated (produced) and the photoelectric conversion efficiency was measured in the same manner as in Example 16, except that the NiO (15 nm film thickness) in Example 16 was changed to CuAlO₂ (70 nm film thickness). The results of the solar cell characteristics are shown in Table 2 below.

### [Example 24]

A photoelectric conversion element was fabricated (produced) and the photoelectric conversion efficiency was measured in the same manner as in Example 16, except that the NiO (15 nm film thickness) in Example 16 was changed to NiAlO₂ (15 nm film thickness). The results of the solar cell characteristics are shown in Table 2 below.

**[Table 2]**

| | Monomolecular hole transport material | p-type metal oxide | Insulating compound | Concentration of insulating compound | Film formation procedure | Solar cell characteristics (best data) | | | | Avg. | Standard deviation σ |
|---|---|---|---|---|---|---|---|---|---|---|---|
| | | | | | | Voc (V) | Jsc (mA/cm²) | FF | PCE (%) | PCE (%) | |
| Example 16 | A-06 | NiO (15 nm) | Al₂O₃ (50 nm) | 0.4 wt% | 1 | 1.15 | 22.8 | 80.2 | 21.0 | 20.3 | 0.45 |
| Example 17 | " | NiO (25 nm) | " | " | " | 1.15 | 22.9 | 80.3 | 21.1 | 20.3 | 0.55 |
| Example 18 | " | NiO (50 nm) | " | " | " | 1.15 | 22.7 | 79.8 | 20.8 | 20.1 | 0.52 |
| Example 19 | " | NiO (70 nm) | " | " | " | 1.16 | 22.5 | 78.3 | 20.4 | 19.6 | 0.44 |
| Example 20 | " | CuAlO₂ (15 nm) | " | " | " | 1.15 | 23.1 | 78.4 | 20.8 | 20.1 | 0.47 |
| Example 21 | " | CuAlO₂ (25 nm) | " | " | " | 1.15 | 22.9 | 78.2 | 20.6 | 19.5 | 0.64 |
| Example 22 | " | CuAlO₂ (50 nm) | " | " | " | 1.15 | 22.5 | 77.9 | 20.2 | 19.4 | 0.55 |
| Example 23 | " | CuAlO₂ (70 nm) | " | " | " | 1.16 | 22.3 | 77.2 | 20.0 | 19.4 | 0.42 |
| Example 24 | " | NiAlO₂ (15 nm) | " | " | " | 1.15 | 22.8 | 79.8 | 20.9 | 20.1 | 0.57 |

As described above, it can be confirmed from the present examples that by using the hole transport material and the insulating compound of the above-described aspects in the hole transport layer, not only can the solar cell characteristics be improved, but also characteristic variation can be reduced.

### [Solar Cell Module]

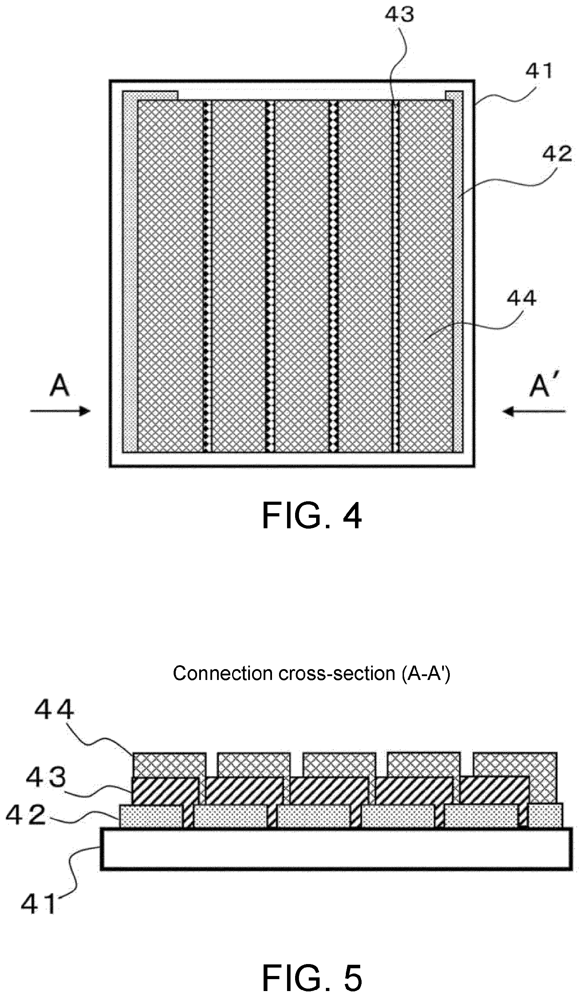

A first electrode 42 was formed on a surface of a glass substrate 41, and the first electrode 42 was patterned into a shape shown in FIG. 2 using a laser processing apparatus. A monomolecular hole transport layer was formed on the first electrode 42, and further, a perovskite layer was obtained as a photoelectric conversion layer. Next, an electron transport layer was formed into a film by vacuum deposition. Thereafter, the photoelectric conversion layer (perovskite layer) was etched using the laser processing apparatus, and a pattern of a photoelectric conversion layer (perovskite layer) 43 as shown in FIG. 3 was formed. Finally, Ag was formed at 70 nm by vacuum deposition, and a second electrode 44 was etched using the laser processing apparatus to obtain a photoelectric conversion module (perovskite solar cell module) having a shape as shown in FIG. 4 and FIG. 5.

The present invention has been described above using the embodiments and examples. However, the present invention is not limited to the embodiments and examples described above, and may be combined, modified, or selected arbitrarily and appropriately as needed within the scope not departing from the spirit of the present invention.

### Industrial Applicability

As described above, the photoelectric conversion element of the present invention is useful as, for example, a solar cell. The application and usage of the photoelectric conversion element of the present invention are not particularly limited, and the photoelectric conversion element may be applied to a wide range of fields in the same applications and usages as those of, for example, a general photoelectric conversion element (for example, general solar cell).

### Cross-Reference to Related Applications

This application claims priority based on Japanese Patent Application No. 2023-198632 filed with the Japan Patent Office on November 22, 2023, the entire disclosure of which is incorporated herein by reference.

### Description of Reference Numerals

- 10: photoelectric conversion element
- 11: support
- 12: first electrode
- 13: hole transport layer
- 14: photoelectric conversion layer
- 15: electron transport layer
- 16: second electrode

## Claims

1. A photoelectric conversion element, **characterized in that** a first electrode, a hole transport layer, a photoelectric conversion layer, and a second electrode are directly or indirectly laminated in this order,
the photoelectric conversion layer comprises a perovskite compound;
the hole transport layer comprises an insulating compound and a compound represented by the following chemical formula (I), the hole transport layer being in contact with a main surface of the first electrode on a side of the photoelectric conversion layer,
Ar¹-(L¹-X¹)n ... (I)
wherein in chemical formula (I), Ar¹ is a structure comprising an aromatic ring, atoms that constitute the aromatic ring may include heteroatoms, and Ar¹ may have a substituent other than - L¹-X¹; n is an integer of 1 or greater, and in a case where n is 2 or greater, structures represented by -L¹-X¹ may be the same as or different from each other; L¹ is a divalent linking group that bonds Ar¹ and X¹, or is a single bond; and X¹ is a group capable of forming a chemical bond or hydrogen bond with the first electrode.

2. The photoelectric conversion element according to claim 1, wherein the hole transport layer comprises a compound represented by the following chemical formula (II),
A¹-L²-X² ... (II)
wherein A¹ is an atomic group comprising one or more substituents or structures selected from a group consisting of an alkoxy group, a hydroxy group, a carboxy group, a dihydroxyphosphoryl group, a dialkylphosphoryl group, a hydroxysulfonyl group, an amino group, a monoalkylamino group, a dialkylamino group, a monoarylamino group, a diarylamino group, a monoalkylaminocarbonyl group, a dialkylaminocarbonyl group, an alkylcarbonyloxy group, an alkoxycarbonyl group, an aminocarbonyl group, an aminocarbonylamino group, an alkylcarbonylamino group, an alkylsulfonylamino group, an aminosulfonyl group, and a nitrogen-containing heterocyclic group; L² is a divalent linking group that bonds A¹ and X², or is a single bond; and X² is a group capable of forming a chemical bond or hydrogen bond with the first electrode.

3. The photoelectric conversion element according to claim 1 or 2, wherein the compound represented by chemical formula (I) forms a monolayer.

4. The photoelectric conversion element according to claim 1 or 2, wherein the insulating compound is at least one selected from a metal oxide, a metal nitride, an insulating organic compound, and an organic-inorganic hybrid compound.

5. The photoelectric conversion element according to claim 4, wherein the insulating compound has a particle shape.

6. The photoelectric conversion element according to claim 5, wherein the insulating compound has an average particle size ranging from 1 nm to 200 nm.

7. The photoelectric conversion element according to claim 1 or 2, wherein X¹ in chemical formula (I) is each selected from a group consisting of a dihydroxyphosphoryl group (-P=O(OH)₂), a carboxy group (-COOH), a sulfo group (-SO₃H), a boronic acid group (-B(OH)₂), a trihalogenated silyl group (-SiX₃, wherein X is a halo group), a trialkoxysilyl group (-Si(OR)₃, wherein R is an alkyl group), a trihydroxysilyl group, and a dialkylphosphoryl group.

8. The photoelectric conversion element according to claim 2, wherein X² in chemical formula (II) is each independently selected from a group consisting of a dihydroxyphosphoryl group (-P=O(OH)₂), a carboxy group (-COOH), a sulfo group (-SO₃H), a boronic acid group (-B(OH)₂), a trihalogenated silyl group (-SiX₃, wherein X is a halo group), a trialkoxysilyl group (-Si(OR)₃, wherein R is an alkyl group), a trihydroxysilyl group, and a dialkylphosphoryl group.

9. The photoelectric conversion element according to claim 1 or 2, wherein the perovskite compound is an organic-inorganic perovskite compound.

10. The photoelectric conversion element according to claim 1 or 2, wherein a mass ratio of a mass (m1) of the compound represented by chemical formula (I) to a mass (m2) of the insulating compound satisfies a relationship of the following formula (A). $m 1 / m 2 = 1 / 10 to 1 / 20000$

11. The photoelectric conversion element according to claim 1 or 2, wherein an intermediate layer comprising nickel oxide is formed between the first electrode and the hole transport layer.

12. A solar cell module, comprising the photoelectric conversion element according to claim 1 or 2.
